# EUROPEAN PATENT APPLICATION

(11) **EP 4 629 798 A2**
(43) Date of publication of application: **08.10.2025**
(21) Application number: 25164706.1
(22) Date of filing: 19.03.2025
(51) Int. Cl.: H10K 59/122, H10K 59/88

(54) **DISPLAY DEVICE AND ELECTRONIC DEVICE INCLUDING THE SAME**

(30) Priority: 02.04.2024 KR 20240044760
(71) Applicant: Samsung Display Co., Ltd., Gyeonggi-do (KR)
(72) Inventor: LEE, Chang-Yeol, Yongin-si (KR); KIM, Jin-Yup, Yongin-si (KR); SONG, Hagyeong, Yongin-si (KR); MOON, Joong-soo, Yongin-si (KR); CHO, Youngjin, Yongin-si (KR)
(74) Representative: Marks & Clerk LLP

(57) **Abstract**

A display device includes a base layer, and a circuit element layer including a driver on the base layer overlapping a non-display region, and a display element layer on the circuit element layer. The display element layer includes a pixel defining layer on the circuit element layer, and a light emission element overlapping a display region including a light emission layer. The pixel defining layer includes a light emission opening overlapping the display region and at least having the light emission layer disposed in the light emission opening, a driving opening overlapping the non-display region, overlapping the driver, and a dummy opening overlapping the non-display region and between the light emission opening and the driving opening. The dummy opening has a substantially planar shape substantially the same as a planar shape of the light emission opening or the driving opening.

## Description

### BACKGROUND

### 1. Technical Field

Embodiments described herein relate to a display device and an electronic device including the same.

### 2. Description of the Related Art

In general, an electronic device, such as a smartphone, a digital camera, a laptop computer, navigation, or a smart television, which provides an image to a user may include a display device to display the image. The display device generates an image and then provides the generated image to the user through a display screen.

The display device may include a plurality of pixels to generate an image and a plurality of lines connected to the pixels. The pixels receive driving signals through lines and are driven.

Recently, as the display device has been developed in various forms, there is required a technology developed to prevent the failure of excessively making the display device bright or dark by uniformly ensuring visibility throughout the entire portion of a display surface of the display device.

It is to be understood that this background of the technology section is, in part, intended to provide useful background for understanding the technology. However, this background of the technology section may also include ideas, concepts, or recognitions that were not part of what was known or appreciated by those skilled in the pertinent art prior to a corresponding effective filing date of the subject matter disclosed herein.

### SUMMARY

Embodiments provide a display device improved in display quality by preventing the display failure in which a portion of a display surface of the display device, especially, a portion of a non-display region adjacent to an end of the display region, is viewed different from another portion of the display surface.

According to an embodiment, a display device includes a base layer divided into a display region and a non-display region surrounding at least a portion of the display region; a circuit element layer including a driver disposed on the base layer and overlapping the non-display region; and a display element layer disposed on the circuit element layer. The display element layer includes a pixel defining layer disposed on the circuit element layer, and a light emission element overlapping the display region and including a light emission layer. The pixel defining layer includes a light emission opening overlapping the display region and at least having the light emission layer disposed in the light emission opening, a driving opening overlapping the non-display region, and overlapping the driver, and a dummy opening overlapping the non-display region and disposed between the light emission opening and the driving opening. The dummy opening has a substantially planar shape substantially the same as a planar shape of the light emission opening or the driving opening.

Each of the light emission opening, the driving opening, and the dummy opening may include a tilting surface having a substantially acute angle with respect to an upper surface of the circuit element layer.

The light emission element may further include an anode disposed on the circuit element layer, and a cathode facing the anode. The light emission layer may be disposed between the anode and the cathode.

The cathode may be disposed on the tilting surface.

The circuit element layer may further include a plurality of insulating layers disposed on the base layer. The anode may be directly disposed on an uppermost layer among the plurality of insulating layers.

The cathode may include a dummy part disposed in the dummy opening. The dummy part may be directly disposed on the uppermost layer among the plurality of insulating layers.

The display element layer may further include a dummy electrode disposed on the circuit element layer. The cathode may include a dummy part disposed in the dummy opening. The dummy part may contact the dummy electrode.

The cathode may include a driving part disposed in the driving opening. The display element layer may further include a voltage line disposed on the circuit element layer. The driving part may contact the voltage line.

Each of the driving opening and the dummy opening may have a shape substantially of a circle, a shape substantially of an oval, a shape substantially of a rectangle, or a shape of a rectangle having a substantially rounded corner, when viewed in a plan view.

A minimum distance between the dummy opening and the light emission opening may be about less than or about equal to a minimum distance between the driving opening and the dummy opening.

The light emission opening may include a first light emission opening, a second light emission opening spaced apart from the first light emission opening, and a third light emission opening spaced apart from each of the first light emission opening and the second light emission opening. The dummy opening may have a shape (e.g. a planar shape) substantially the same as a shape (e.g. a planar shape) of at least one of the first light emission opening, the second light emission opening, and the third light emission opening, when viewed in a plan view.

The display region may include a first side extending in a first direction, a second side extending in a second direction intersecting the first direction adjacent to an end of the first side, and a first substantially rounded corner connecting the end of the first side to an end, adjacent to the end of the first side, of the second side.

The dummy opening may be adjacent to at least one of the first side, the second side, and the substantially first rounded corner.

According to an embodiment, a display device may include a window disposed on the display element layer. The window may include a base member, and a light blocking pattern disposed below the base member and overlapping the non-display region. Each of the driving opening and the dummy opening may be closer to the display region, rather than to the light blocking pattern, when viewed in a plan view.

The dummy region including the dummy opening may extend in a direction intersecting a direction in which the light emission opening and the driving opening are spaced apart from each other.

The dummy region for the dummy opening may have a width in a range of about 40 µm to about 80 µm.

The dummy opening may include a first dummy opening adjacent to the driving opening, and a second dummy opening disposed between the first dummy opening and the light emission opening when viewed in a plan view.

The circuit element layer may include at least one transistor electrically connected to the light emission element.

According to an embodiment, a display device includes a base layer divided into a display region and a non-display region surrounding at least a portion of the display region; a circuit element layer including a driver disposed on the base layer and overlapping the non-display region; and a display element layer disposed on the circuit element layer. The display element layer includes a pixel defining layer disposed on the circuit element layer, and a light emission element overlapping the display region. The pixel defining layer includes a light emission opening overlapping the display region, a driving opening overlapping the non-display region and overlapping the driver, and a dummy opening overlapping the non-display region and disposed between the light emission opening and the driving opening. Each of the light emission opening, the driving opening, and the dummy opening includes a tilting surface having a substantially acute angle with respect to an upper surface of the circuit element layer.

The light emission element may include an anode disposed on the circuit element layer, a cathode facing the anode, and a light emission layer disposed between the anode and the cathode. The cathode may be disposed on the tilting surface.

According to an embodiment, a display device may include a base layer divided into a display region and a non-display region surrounding at least a portion of the display region; a circuit element layer including a driver disposed on the base layer and overlapping the non-display region, and a display element layer disposed on the circuit element layer. The display element layer may include a pixel defining layer disposed on the circuit element layer, and a light emission element overlapping the display region. The pixel defining layer may include a light emission opening overlapping the display region, a driving opening overlapping the non-display region and overlapping the driver, and a dummy opening disposed between the light emission opening and the driving opening and being in a non-overlap state with the driver.

According to an embodiment, an electronic device includes a display module including a display panel, and a processor including at least one of a central processing unit, an application processor, a graphic processing unit, a communication processor, an image signal processor, and a controller. The display panel includes a base layer divided into a display region and a non-display region surrounding at least a portion of the display region; and a circuit element layer including a driver disposed on the base layer and overlapping the non-display region; and a display element layer disposed on the circuit element layer. The display element layer includes a pixel defining layer disposed on the circuit element layer, and a light emission element overlapping the display region and including a light emission layer. The pixel defining layer includes a light emission opening overlapping the display region and at least having the light emission layer disposed in the light emission opening, a driving opening overlapping the non-display region, and overlapping the driver, and a dummy opening overlapping the non-display region and disposed between the light emission opening and the driving opening. The dummy opening has a substantially planar shape substantially the same as a planar shape of the light emission opening or the driving opening.

According to an embodiment, the electronic device may be a television, a monitor, an external billboard, a personal computer, a notebook computer, a personal digital terminal, car navigation, a game console, a smartphone, a tablet, or a camera.

At least some of the above and other features of the invention are set out in the claims.

### BRIEF DESCRIPTION OF THE DRAWINGS

The above and other objects and features of the disclosure will become apparent by describing in detail embodiments thereof with reference to the accompanying drawings in which:
FIG. 1 is a schematic perspective view of a display device according to an embodiment.
FIG. 2 is a schematic cross-sectional view of a display device according to an embodiment.
FIG. 3 is a schematic cross-sectional view of a display panel according to an embodiment.
FIG. 4 is a block diagram of a display device according to an embodiment.
FIG. 5 is a schematic diagram of an equivalent circuit of a pixel according to an embodiment.
FIG. 6 is a schematic cross-sectional view of a display panel according to an embodiment.
FIG. 7 is a schematic plan view of a display panel according to an embodiment.
FIG. 8 is an enlarged schematic plan view of a display region according to an embodiment.
FIG. 9 is an enlarged schematic plan view of a portion of a display panel according to an embodiment.
FIGS. 10 to 12 are enlarged schematic plan views of various components of a display panel according to an embodiment.
FIG. 13 is an enlarged schematic plan view of various components of a display panel according to an embodiment.
FIGS. 14A and 14B are schematic cross-sectional views illustrating various components of a display panel according to an embodiment.
FIG. 15 is a block diagram of an electronic device according to one embodiment.
FIG. 16 is a schematic diagram of an electronic device according to various embodiments.

### DETAILED DESCRIPTION OF THE EMBODIMENTS

In the specification, the expression that a first component (or region, layer, part, portion, etc.) is "on", "connected to", or "coupled to" a second component means that the first component is directly on, connected to, or coupled to the second component or means that a third component is disposed therebetween.

The disclosure will now be described more fully hereinafter with reference to the accompanying drawings, in which embodiments are shown. This disclosure may, however, be embodied in different forms and should not be construed as limited to the embodiments set forth herein. Rather, these embodiments are provided so that this disclosure will be thorough and complete, and will fully convey the scope of the disclosure to those skilled in the art.

The same reference numeral will be assigned to the same component. In the drawings, thicknesses, proportions, and dimensions of components may be exaggerated to describe the technical features effectively.

As used herein, the singular forms, "a," "an," and "the" are intended to include the plural forms as well, unless the context clearly indicates otherwise.

In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or."

In the specification and the claims, the phrase "at least one of" is intended to include the meaning of "at least one selected from the group of" for the purpose of its meaning and interpretation. For example, "at least one of A and B" may be understood to mean "A, B, or A and B."

Although the terms "first", or "second" may be used to describe various components, the components should not be construed as being limited by the terms. The terms are only used to distinguish one component from another component. For example, without departing from the scope of the disclosure, a first component may be referred to as a second component, and similarly, the second component may be referred to as the first component.

The terms "under", "at a lower portion", "above", "an upper portion" are used to describe the relationship between components illustrated in the drawings. The terms are relative and are described with reference to a direction indicated in the drawing.

The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art.

The terms "face" and "facing" mean that a first element may directly or indirectly oppose a second element. In a case in which a third element intervenes between the first and second element, the first and second element may be understood as being indirectly opposed to one another, although still facing each other.

When an element is described as 'not overlapping' or 'to not overlap' another element, this may include that the elements are spaced apart from each other, offset from each other, or set aside from each other or any other suitable term as would be appreciated and understood by those of ordinary skill in the art.

It will be further understood that the terms "comprises," "comprising," "includes," and/or "including," "has," "have," and/or "having," and variations thereof when used in this specification, specify the presence of stated features, integers, steps, operations, elements, components, and/or groups thereof, but do not preclude the presence or addition of one or more other features, integers, steps, operations, elements, components, and/or groups thereof.

In the specification, the wording "a certain member is directly disposed" may refer to that an additional layer, film, region, or plate is absent between a part, such as a layer, film, region, or plate, and another part, such as another layer, film, region, or plate. For example, the wording "a certain member is directly disposed" may refer to that the member is disposed without an additional member, such as an adhesive member, between two layers or two members.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Unless otherwise defined, all terms (including technical terms and scientific terms) used in the specification have the same meaning as commonly understood by one skilled in the art to which the disclosure belongs. Furthermore, terms such as terms defined in the dictionaries commonly used should be interpreted as having a meaning consistent with the meaning in the context of the related technology, and should not be interpreted in an ideal or overly formal meaning unless explicitly defined herein.

It will be understood that when an element (or a region, a layer, a portion, or the like) is referred to as "being on", "connected to" or "coupled to" another element in the specification, it can be directly disposed on, connected or coupled to another element mentioned above, or intervening elements may be disposed therebetween.

It will be understood that the terms "connected to" or "coupled to" may include a physical or electrical connection or coupling.

Embodiments may be described and illustrated in the accompanying drawings in terms of functional blocks, units, and/or modules.

Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies.

In the case of the blocks, units, and/or modules being implemented by microprocessors or other similar hardware, they may be programmed and controlled using software (for example, microcode) to perform various functions discussed herein and may optionally be driven by firmware and/or software.

It is also contemplated that each block, unit, and/or module may be implemented by dedicated hardware, or as a combination of dedicated hardware to perform some functions and a processor (for example, one or more programmed microprocessors and associated circuitry) to perform other functions.

Each block, unit, and/or module of embodiments may be physically separated into two or more interacting and discrete blocks, units, and/or modules without departing from the scope of the disclosure.

Further, the blocks, units, and/or modules of embodiments may be physically combined into more complex blocks, units, and/or modules without departing from the scope of the disclosure.

Hereinafter, embodiments will be described with reference to accompanying drawings.

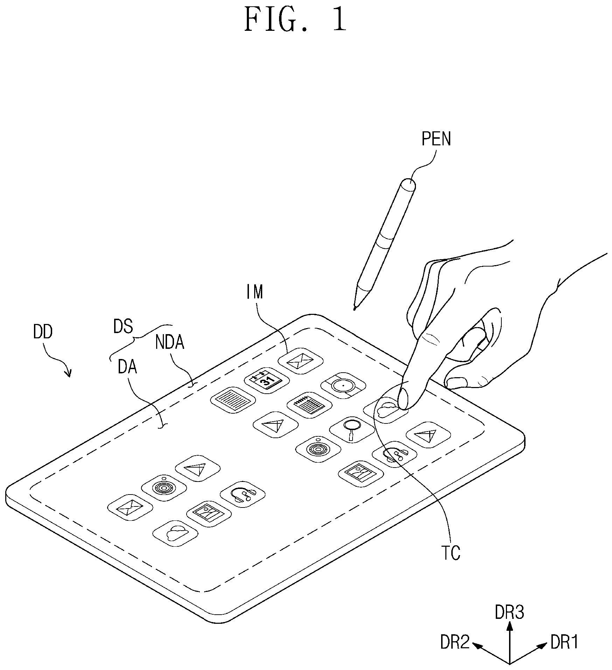

FIG. 1 is a schematic perspective view of a display device according to an embodiment.

Referring to FIG. 1, a display device DD according to an embodiment may have longer sides extending in parallel in a first direction DR1 and shorter sides extending in parallel in a second direction DR2 intersecting the first direction DR1. Corners of the display device DD, which link the longer sides to the shorter sides, may have a curved shape. The corners of the display device DD having the curved shape may be defined as rounded corners. Such a shape of the display device DD may be defined as a round-corner rectangle.

Hereinafter, a direction substantially perpendicular to a plane defined by the first direction DR1 and the second direction DR2 is defined as a third direction DR3. In the specification, the meaning of the wording "when viewed in a plan view" is defined as a state viewed from the third direction DR3.

A front surface of the display device DD may be defined as a display surface DS, and may have a plane defined by the first direction DR1 and the second direction DR2. Images IM generated in the display device DD may be provided to a user through the display surface DS.

The display surface DS may include a display region DA and a non-display region NDA around the display region DA. The display region DA may display an image, and the non-display region NDA may not display an image. The non-display region NDA may surround or may be adjacent to the display region DA and may define an edge of the display device DD, which is printed in a given color.

The display region DA may have a round-corner rectangular shape, depending on the display device DD. For example, the display region DA may include sides of a rectangle extending in the first direction DR1 and the second direction DR2, and rounded corners linking the sides. Sides, which extend in the first direction DR1, among four sides may be defined the longer sides, and sides, which extend in the second direction DR2, among the four sides may be defined the shorter sides.

The display device DD may sense inputs applied from the outside of the display device DD. For example, the display device DD may sense a first input made by a touch pen PEN and a second input made through a touch TC. The touch pen PEN may be defined as an input device.

The touch pen PEN may be an active pen that outputs a signal. The second input made through the touch TC may include various types of external inputs made by, for example, a part of a user body, light, heat, or pressure.

The display device DD and the touch pen PEN may make bidirectional communication. The display device DD may provide an uplink signal to the touch pen PEN. For example, although the uplink signal may include panel information and information, such as a protocol version, the disclosure is not limited thereto.

The touch pen PEN may provide a downlink signal to the display device DD. The downlink signal may include a synchronization signal or information about the state of the touch pen PEN. For example, although the downlink signal may include information about coordinates of the touch pen PEN, information about a battery of the touch pen PEN, information about a gradient of the touch pen PEN, and/or various pieces of information stored in the touch pen PEN, the disclosure is not limited thereto.

The display device DD may be used in larger electronic devices such as a television, a monitor, or an external billboard. The display device DD may be used in smaller and medium-sized electronic devices such as a personal computer, a notebook computer, a personal digital terminal, car navigation, a game console, a smartphone, a tablet, or a camera. However, the types of the display device DD are provided only for the illustrative purpose. For example, the display device DD may be employed to other electronic devices without deviating from the scope of the disclosure.

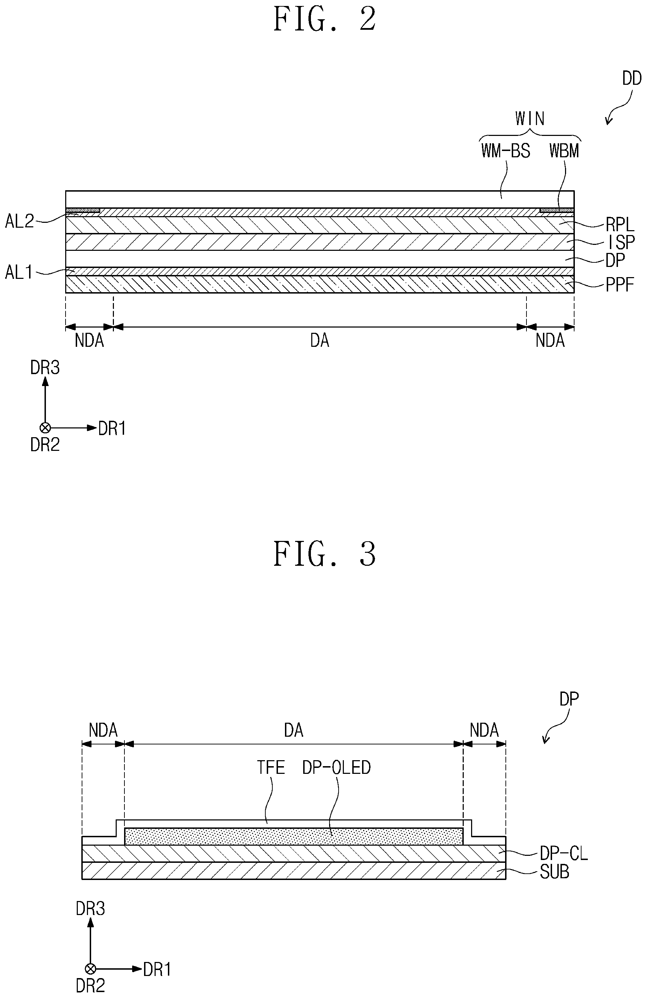

FIG. 2 is a schematic cross-sectional view of a display device according to an embodiment. FIG. 2 is a schematic cross-sectional view illustrating the display device of FIG. 1. FIG. 2 illustrates the cross-section of the display device DD when viewed in the second direction DR2, by way of example.

Referring to FIG. 2, the display device DD may include a display panel DP, an input sensing unit ISP, an anti-reflective layer RPL, a window WIN, a panel protecting film PPF, and first and second adhesive layers AL1 and AL2.

The display panel DP according to an embodiment may include an emissive-type display panel. For example, the display panel DP may be an organic light emission display panel or an inorganic light emission display panel. A light emission layer of the organic light emission display panel may include an organic light emission material. A light emission layer of the inorganic light emission display panel may include a quantum dot and a quantum rod. In the following description, the display panel DP will function as the organic light emission display panel.

The input sensing unit ISP may be disposed on the display panel DP. The input sensing unit ISP may include a plurality of sensing units to sense an external input in a capacitive manner. The input sensing unit ISP may be fabricated directly on the display panel DP in the case that the display device DD is fabricated. However, the disclosure is not limited thereto. For example, the input sensing unit ISP may be fabricated in the form of a panel separate from the display panel DP and attached to the display panel DP by an adhesive layer.

The anti-reflective layer RPL may be disposed on the input sensing unit ISP. The anti-reflective layer RPL may be directly fabricated on the input sensing unit ISP, in the case that the display device DD is fabricated. However, the disclosure is not limited thereto. For example, the anti-reflective layer RPL may be fabricated in the form of a separate panel and may be bonded to the input sensing unit ISP through an adhesive layer.

The anti-reflective layer RPL may be defined as a film to prevent external light from being reflected. The anti-reflective layer RPL may reduce the reflectance of the external light incident from an upper portion of the display device DD toward the display panel DP. The external light may not be viewed to the user due to the anti-reflective layer RPL.

In the case that the external light toward the display panel DP is reflected from the display panel DP and provided again to an external user, the user may view the external light, which is similar to a mirror. To prevent the above phenomenon, the anti-reflective layer RPL may include a plurality of color filters to display the same color as that of pixels of the display panel DP.

The color filters may filter the external light in the same color as that of the pixels. In this case, the external light may not be viewed by the user. However, the disclosure is not limited thereto. For example, the anti-reflective layer RPL may include a phase retarder and/or a polarizer, to reduce the reflectance of the external light.

The window WIN may be disposed on the anti-reflective layer RPL. The window WIN may protect the display panel DP, the input sensing unit ISP, and the anti-reflective layer RPL from external scratches and impacts.

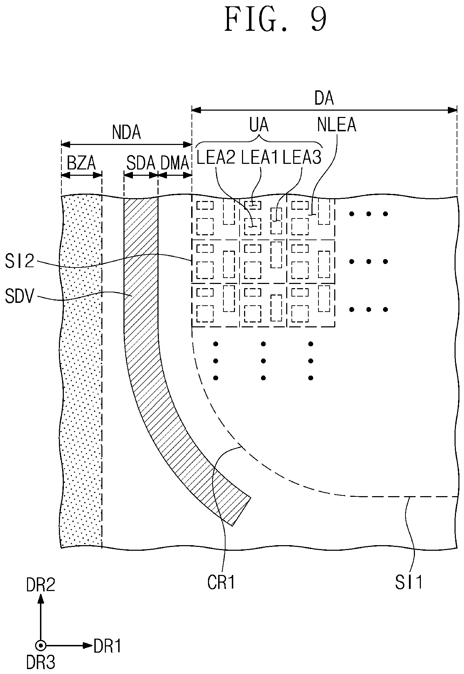

As illustrated in FIG. 2, the window WIN may include a base member WM-BS and a light blocking pattern WBM for defining a bezel region BZA (see FIG. 9). The light blocking pattern WBM, which serves as a colored organic film, may be formed on one surface or a surface of the base member WM-BS, for example, in a coating scheme. The light blocking pattern WBM may be formed under or below the base member WM-BS.

The panel protecting film PPF may be disposed under or below the display panel DP. The panel protecting film PPF may protect a lower portion of the display panel DP. The panel protecting film PPF may include a flexible plastic material such as polyethyleneterephthalate (PET).

A first adhesive layer AL1 may be disposed between the display panel DP and the panel protecting film PPF, and the display panel DP and the panel protecting film PPF may be bonded to each other by the first adhesive layer AL1. A second adhesive layer AL2 may be disposed between the window WIN and the anti-reflective layer RPL, and the window WIN and the anti-reflective layer RPL may be bonded to each other by the second adhesive layer AL2.

FIG. 3 is a schematic cross-sectional view of a display panel according to an embodiment. FIG. 3 is a schematic cross-sectional view illustrating the display panel of FIG. 2. FIG. 3 illustrates the cross-section of the display panel DP when viewed in the second direction DR2, by way of example.

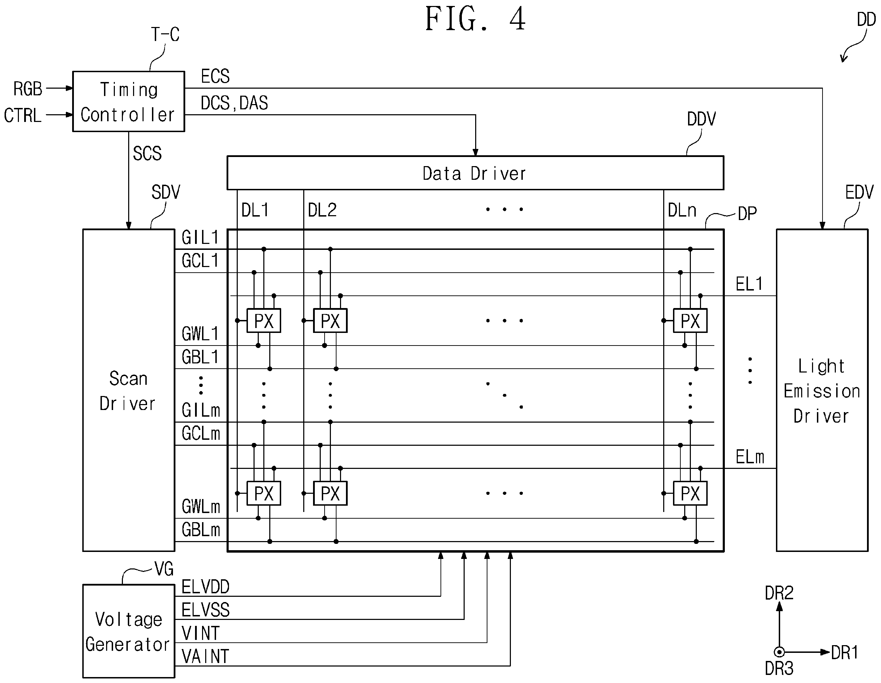

Referring to FIG. 3, the display panel DP may include a base layer SUB, a circuit element layer DP-CL disposed on the base layer SUB, a display element layer DP-OLED disposed on the circuit element layer DP-CL, and a thin film encapsulating layer TFE disposed on the display element layer DP-OLED. The circuit element layer DP-CL may include a driver that may include a scan driver SDV (FIG. 4), a data driver DDV (FIG. 4), and a light emission driver EDV (FIG. 4).

The base layer SUB may include the display region DA and the non-display region NDA around the display region DA. The base layer SUB may be divided into the display region DA and the non-display region NDA around the display region DA. The base layer SUB may include glass or a flexible plastic material such as polyimide (PI). The display element layer DP-OLED may be disposed in the display region DA.

A plurality of pixels may be disposed on the circuit element layer DP-CL and the display element layer DP-OLED. Each of the pixels may include a transistor disposed in the circuit element layer DP-CL and a light emission element disposed in the display element layer DP-OLED to be connected to the transistor.

The thin film encapsulating layer TFE may be disposed on the circuit element layer DP-CL to cover the display element layer DP-OLED. The thin film encapsulating layer TFE may protect the pixels from moisture, oxygen, and external foreign substances.

FIG. 4 is a block diagram of a display device according to an embodiment. A block diagram of the display device illustrated in FIG. 1 is illustrated in FIG. 4.

Referring to FIG. 4, the display device DD may include the display panel DP, a timing controller T-C, a scan driver SDV, a data driver DDV, a light emission driver EDV, and a voltage generator VG.

The display panel DP may include a plurality of scan lines GIL1 to GILm, GCL1 to GCLm, GWL1 to GWLm, and GBL1 to GBLm, a plurality of light emission lines EL1 to ELm, a plurality of data lines DL1 to DLn, and a plurality of pixels PX. In this case, 'm' and 'n' are natural numbers.

Pixels PX may be electrically connected to the scan lines GIL1 to GILm, GCL1 to GCLm, GWL1 to GWLm, and GBL1 to GBLm, the light emission lines EL1 to ELm, and the data lines DL1 to DLn, respectively. Each of the pixels PX may be electrically connected to four relevant scan lines, one relevant data line, and one relevant light emission line.

The scan lines GIL1 to GILm, GCL1 to GCLm, GWL1 to GWLm, and GBL1 to GBLm may include the plurality of initializing scan lines GIL1 to GILm, the plurality of compensating scan lines GCL1 to GCLm, the plurality of write scan lines GWL1 to GWLm, and the plurality of bias scan lines GBL1 to GBLm.

Each of the pixels PX may be connected to a relevant one of the plurality of initializing scan lines GIL1 to GILm, a relevant one of the plurality of compensating scan lines GCL1 to GCLm, a relevant one of the plurality of write scan lines GWL1 to GWLm, and a relevant one of the plurality of bias scan lines GBL1 to GBLm.

The scan lines GIL1 to GILm, GCL1 to GCLm, GWL1 to GWLm, and GBL1 to GBLm may be connected to the scan driver SDV while extending in the first direction DR1, and may be arranged (or disposed) in the second direction DR2. The light emission lines EL1 to ELm may be connected to the light emission driver EDV while extending in the first direction DR1, and may be arranged in the second direction DR2. The data lines DL1 to DLn may be connected to the data driver DDV while extending in the second direction DR2, and may be arranged in the first direction DR1.

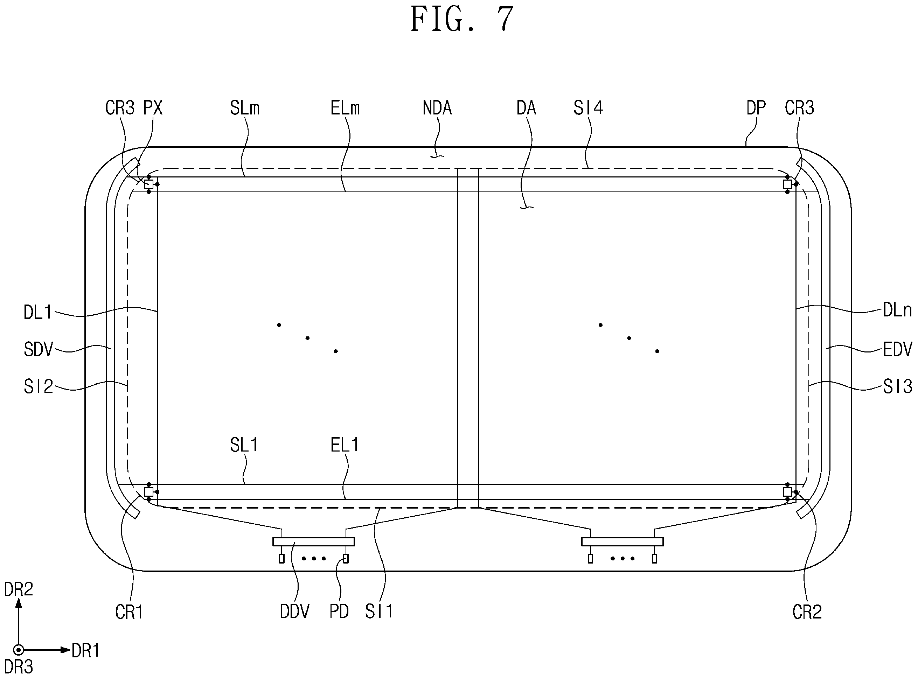

The scan driver SDV, the light emission driver EDV, and the data driver DDV may be substantially disposed in the display panel DP, and the configuration thereof will be described with reference to FIG. 7 below.

The timing controller T-C may receive an image signal RGB and a control signal CTRL. The timing controller T-C may generate an image data signal DAS generated by converting a data format of the image signal RGB to be matched with an interface specification with the data driver DDV. The timing controller T-C may output a scan control signal SCS, a data control signal DCS, and an emission control signal ECS, in response to the control signal CTRL.

The voltage generator VG may generate voltage desirable for the operations of the display panel DP. The voltage generator VG may generate a first driving voltage ELVDD, a second driving voltage ELVSS, a first initializing voltage VINT, and a second initializing voltage VAINT. The first driving voltage ELVDD, the second driving voltage ELVSS, the first initializing voltage VINT, and the second initializing voltage VAINT may be applied to the pixels PX.

The scan driver SDV may receive the scan control signal SCS from the timing controller T-C. The scan driver SDV may output scan signals to the scan lines GIL1 to GILm, GCL1 to GCLm, GWL1 to GWLm, and GBL1 to GBLm, in response to the scan control signal SCS. The scan signals may be applied to the pixels PX through the scan lines GIL1 to GILm, GCL1 to GCLm, GWL1 to GWLm, and GBL1 to GBLm.

The data driver DDV may receive the data control signal DCS and the image data signal DAS from the timing controller T-C. The data driver DDV may convert the image data signal DAS into data signals to be output. The data signals may be defined analog voltages corresponding to gray levels of the image data signal DAS. The data signals may be applied to the pixels PX through the data lines DL1 to DLn.

The light emission driver EDV may receive the emission control signal ECS from the timing controller T-C. The light emission driver EDV may output emission signals to the light emission lines EL1 to ELm, in response to the emission control signal ECS. The emission signals may be applied to the pixels PX through the light emission lines EL1 to ELm.

The pixels PX may receive data voltages in response to the scan signals. The pixels PX may emit light having brightness corresponding to the data voltages in response to the emission signals to display an image.

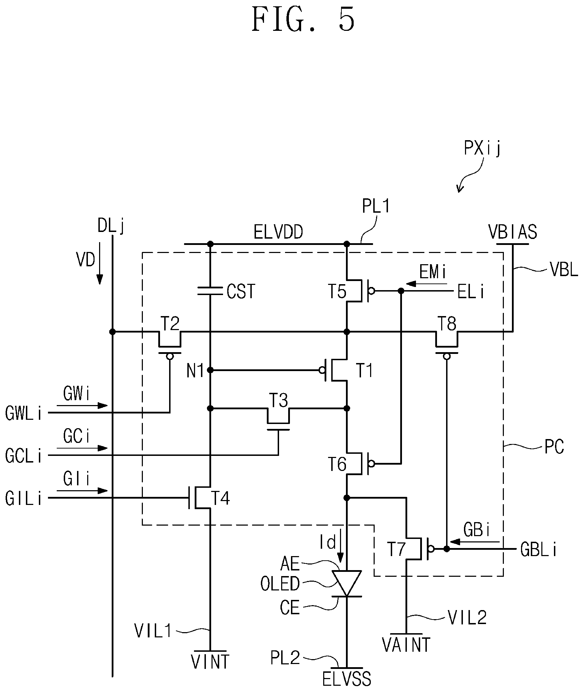

FIG. 5 is a schematic diagram of an equivalent circuit of a pixel according to an embodiment. FIG. 5 illustrates a schematic diagram of an equivalent circuit of any one of the pixels illustrated in FIG. 4 is illustrated in FIG. 5.

FIG. 5 illustrates a pixel PXij connected to a j-th data line DLj, an i-th scan lines GWLi, GCLi, GILi, and GBLi, and an i-th light emission line ELi, by way of example. In this case, 'i' and 'j' are natural numbers.

Referring to FIG. 5, the pixel PXij may include a pixel circuit PC and a light emission element OLED connected to the pixel circuit PC. The pixel circuit PC may drive the light emission element OLED.

The pixel circuit PC may include a plurality of transistors T1 to T8 and a capacitor CST. The transistors T1 to T8 and the capacitor CST may control a quantity of current Id flowing through the light emission element OLED. The light emission element OLED generates light having a given brightness based on the quantity of current received therein.

The i-th write scan line GWLi may receive the i-th write scan signal GWi, and the i-th compensating scan line GCLi may receive the i-th compensating scan signal GCi. The i-th initializing scan line GILi may receive the i-th initializing scan signal GIi, and the i-th bias scan line GBLi may receive the i-th bias scan signal GBi. The i-th light emission line ELi may receive an i-th emission signal EMi.

The pixel PXij may be connected to the j-th data line DLj, the i-th write scan line GWLi, the i-th compensating scan line GCLi, the i-th initializing scan line GILi, the i-th bias scan line GBLi, the i-th light emission line ELi, a first initializing line VIL1, a second initializing line VIL2, a bias line VBL, and first and second power lines PL1 and PL2.

The first initializing line VIL1 may be to receive the first initializing voltage VINT, and the second initializing line VIL2 may be to receive the second initializing voltage VAINT. The bias line VBL may be to receive the bias voltage VBIAS. The first power line PL1 may be to receive the first driving voltage ELVDD and, the second power line PL2 may be to receive the second driving voltage ELVSS.

Each of the first to eighth transistors T1 to T8 may include a source electrode, a drain electrode, and a gate electrode. Hereinafter, as illustrated in FIG. 5, any one of the source electrode and the drain electrode is defined as a first electrode, and another of the source electrode and the drain electrode is defined as a second electrode. The gate electrode is defined as a control electrode.

The transistors T1 to T8 may include the first to eighth transistors T1 to T8. The first and second transistors T1 and T2, and the fifth to eighth transistors T5 to T8 may be PMOS transistors. The third and fourth transistors T3 and T4 may be NMOS transistors.

The first transistor T1 may be defined as a driving transistor, and the second transistor T2 may be defined as a switching transistor. The third transistor T3 may be defined as a compensating transistor. The fourth transistor T4 and the seventh transistor T7 may be defined as initializing transistors. The fifth transistor T5 and the sixth transistor T6 may be defined as light emission control transistors. The eighth transistor T8 may be defined as a bias transistor.

The light emission element OLED may be defined an organic light emission element. The light emission element OLED may include an anode AE and a cathode CE. The anode AE may receive the first driving voltage ELVDD through the sixth, first, and fifth transistors T6, T1, and T5. The first driving voltage ELVDD may be applied to the pixel circuit PC through the first power line PL1.

The cathode CE may receive the second driving voltage ELVSS having a level lower than a level of the first driving voltage ELVDD. The second driving voltage ELVSS may be applied to the pixel circuit PC through the second power line PL2.

The first transistor T1 may be disposed between the fifth transistor T5 and the sixth transistor T6 and may be connected to the fifth transistor T5 and the sixth transistor T6. The first transistor T1 may be connected to the first power line PL1 through the fifth transistor T5, and may be connected to the anode AE through the sixth transistor T6.

The first transistor T1 may include a first electrode connected to the first power line PL1 through the fifth transistor T5, a second electrode connected to the anode AE through the sixth transistor T6, and a control electrode connected to the first node N1.

The first electrode of the first transistor T1 may be connected to the fifth transistor T5, and the second electrode of the first transistor T1 may be connected to the sixth transistor T6. The first transistor T1 may control the quantity of current flowing through the light emission element OLED depending on the voltage across the first node N1, which is applied to the control electrode of the first transistor T1.

The second transistor T2 may be disposed between the first transistor T1 and the j-th data line DLj and may be connected to the first transistor T1 and the j-th data line DLj. The second transistor T2 may include a first electrode connected to the j-th data line DLj, a second electrode connected to the first electrode of the first transistor T1, and a control electrode connected to the i-th write scan line GWLi.

The second transistor T2 may be turned on in response to the i-th write scan signal GWi received through the i-th write scan line GWLi to electrically connect the j-th data line DLj to the first electrode of the first transistor T1. The second transistor T2 may perform a switching operation to apply a data voltage VD (corresponding to the above-described data signal), which is received through the j-th data line DLj, to the first electrode of the first transistor T1.

The third transistor T3 may be connected to the second electrode of the first transistor T1 and a first node N1. The third transistor T3 may include a first electrode connected to the second electrode of the first transistor T1, a second electrode connected to the first node N1, and a control electrode connected to the i-th compensating scan line GCLi.

The third transistor T3 may be turned on in response to the i-th compensating scan signal GCi, which is received through the i-th compensating scan line GCLi, to electrically connect the second electrode of the first transistor T1 to the control electrode of the first transistor T1. In the case that the third transistor T3 is turned on, the first transistor T1 and the third transistor T3 may be connected to each other in the form of a diode.

The fourth transistor T4 may be connected to the first node N1. The fourth transistor T4 may include a first electrode connected to the first node N1, a second electrode connected to the first initializing line VIL1, and a control electrode connected to the i-th initializing scan line GILi. The fourth transistor T4 may be turned on in response to the i-th initializing scan signal GIi received through the i-th initializing scan line GILi to apply the first initializing voltage VINT, which is received through the first initializing line VIL1, to the first node N1.

The fifth transistor T5 may include a first electrode connected to the first power line PL1, a second electrode connected to the first electrode of the first transistor T1, and a control electrode connected to the i-th light emission line ELi.

The sixth transistor T6 may include a first electrode connected to the second electrode of the first transistor T1, a second electrode connected to the anode AE, and a control electrode connected to the i-th light emission line ELi.

The fifth transistor T5 and the sixth transistor T6 may be turned on in response to the i-th emission signal EMi which is received through the i-th light emission line ELi. The first driving voltage ELVDD is provided to the light emission element OLED through the fifth transistor T5 and the sixth transistor T6 turned on, such that the driving current flows to the light emission element OLED. Accordingly, the light emission element OLED may emit light.

The seventh transistor T7 may include a first electrode connected to the anode AE, a second electrode connected to the second initializing line VIL2, and a control electrode connected to the i-th bias scan line GBLi. The seventh transistor T7 may be turned on in response to the i-th bias scan signal GBi received through the i-th bias scan line GBLi, such that the second initializing voltage VAINT received through the second initializing line VIL2 is provided to the anode AE of the light emission element OLED.

According to an embodiment, the second initializing voltage VAINT may have a level different from a level of the first initializing voltage VINT. However, the disclosure is not limited thereto. For example, the second initializing voltage VAINT may have a level equal to a level of the first initializing voltage VINT.

The seventh transistor T7 may improve the ability of the pixel PXij to express black color. In the case that the seventh transistor T7 is turned on, a parasitic capacitor of the light emission element OLED may be discharged. Accordingly, in the case that black brightness is implemented, the light emission element OLED does not emit light by a leakage current of the fourth transistor T4. Accordingly, the ability to express black color may be improved.

The capacitor CST may include a first electrode connected to the first power line PL1 and a second electrode connected to the first node N1. In the case that the fifth transistor T5 and the sixth transistor T6 are turned on, the quantity of current flowing through the first transistor T1 may be determined depending on the voltage storage in the capacitor CST.

The eighth transistor T8 may include a first electrode connected to the bias line VBL, a second electrode connected to the first electrode of the first transistor T1, and a control electrode connected to the i-th bias scan line GBLi.

The eighth transistor T8 may be turned on in response to the i-th bias scan signal GBi to apply the bias voltage VBIAS, received through the bias line VBL, to the first electrode of the first transistor T1.

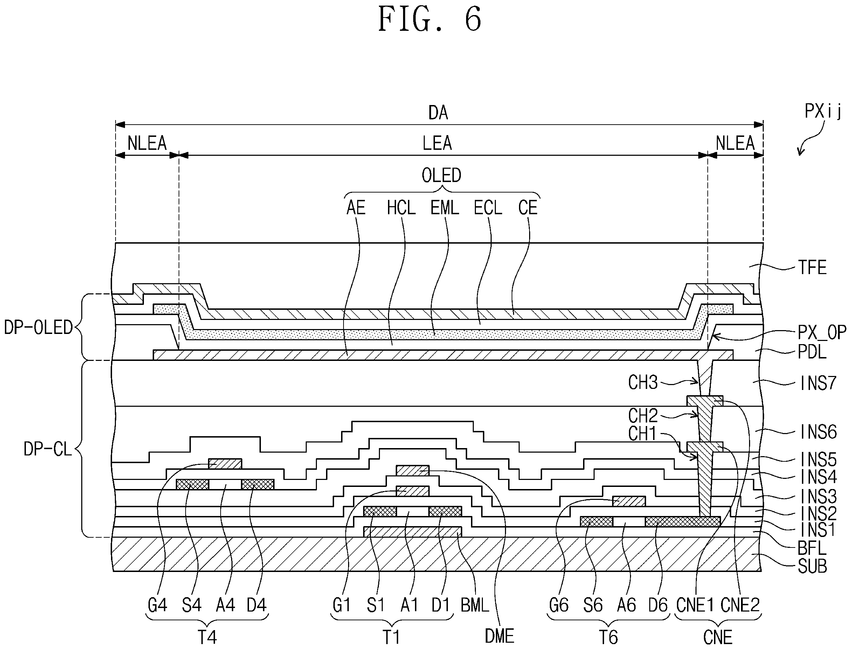

FIG. 6 is a schematic cross-sectional view of a display panel according to an embodiment. The cross-sections of the light emission element, the first transistor, the fourth transistor, and the sixth transistor of the pixel, which are illustrated in FIG. 5, among components of the display panel are illustrated in FIG. 6.

Referring to FIG. 6, the light emission element OLED may include an anode AE, a cathode CE, a hole control layer HCL, an electron control layer ECL, and a light emission layer EML. The anode AE may correspond to the anode AE illustrated in FIG. 5, and the cathode CE may correspond to the cathode CE illustrated in FIG. 5. The cathode CE may be disposed on the anode AE, and the hole control layer HCL, the electron control layer ECL, and the light emission layer EML may be disposed between the anode AE and the cathode CE. Each of the anode AE and the cathode CE may include a metal material. Each of the anode AE and the cathode CE may include reflective metal.

The first, fourth, and sixth transistors T1, T4, and T6 and the light emission element OLED may be disposed on the base layer SUB. The display region DA may include a light emission region LEA corresponding to the pixel PXij and a non-light emission region NLEA adjacent to the light emission region LEA. The light emission element OLED may be disposed in the light emission region LEA.

A lower metal layer BML may be disposed on the base layer SUB. The lower metal layer BML may be overlapping the first transistor T1. The lower metal layer BML may receive a constant voltage. In the case that the constant voltage is applied to the lower metal layer, a threshold voltage value of the first transistor T1 disposed on the lower metal layer BML may be maintained without change.

The lower metal layer BML may block light incident onto the first transistor T1 from a lower portion of the first transistor T1. The lower metal layer BML may include reflective metal. According to an embodiment, the lower metal layer BML may be omitted in the display device.

A buffer layer BFL may be disposed on the base layer SUB. The buffer layer BFL may be an inorganic layer. The buffer layer BFL may cover the lower metal layer BML. The semiconductor layers S1, A1, and D1 of the first transistor T1 and the semiconductor layers S6, A6, and D6 of the sixth transistor T6 may be disposed on the buffer layer BFL. The semiconductor layers S1, A1, D1, S6, A6, and D6 may include polysilicon. However, the disclosure is not limited thereto. For example, the semiconductor layers S1, A1, D1, S6, A6, and D6 may include amorphous silicon.

The semiconductor layers S1, A1, D1, S6, A6, and D6 may be doped with an N-type dopant or a P-type dopant. The semiconductor layers S1, A1, D1, S6, A6, and D6 may include a heavily-doped region and a lightly-doped region. The conductivity of the heavily-doped region is greater than that of the lightly-doped region, and may substantially serve as a source electrode and a drain electrode of the first and sixth transistors T1 and T6. The lightly-doped region may substantially correspond to an active (or channel) of the first and sixth transistors T1 and T6.

The first source region S1, the first channel region A1, and the first drain region D1 of the first transistor T1 may be formed from the semiconductor layers S1, A1, and D1. The sixth source region S6, the sixth channel region A6, and the sixth drain region D6 of the sixth transistor T6 may be formed from the semiconductor layers S6, A6, and D6. The first channel region A1 may be disposed between the first source region S1 and the first drain region D1. The sixth channel region A6 may be disposed between the sixth source region S6 and the sixth drain region D6.

A first insulating layer INS1 may be disposed on the buffer layer BFL to cover the semiconductor layers S1, A1, D1, S6, A6, and D6. The first gate electrode G1 (or a control electrode) of the first transistor T1 and the sixth gate electrode G6 (or control electrode) of the sixth transistors T6 may be disposed on the first insulating layer INS1. When viewed in a plan view, the first gate electrode G1 may be overlapping the first channel region A1, and the sixth gate electrode G6 may be overlapping the sixth channel region A6.

The structures of the source region, the channel region, the drain region, and the gate electrode of each of the second, fifth, and seventh transistors T2, T5, and T7 may be the same as that of the first and sixth transistors T1 and T6.

A second insulating layer INS2 may be disposed on the first insulating layer INS1 to cover the first and sixth gate electrodes G1 and G6. A dummy electrode DME may be disposed on the second insulating layer INS2. The dummy electrode DME may be disposed on the first gate electrode G1, and may be overlapping the first gate electrode G1, when viewed in a plan view. The dummy electrode DME and the first gate electrode G1 may form the capacitor CST described above.

A third insulating layer INS3 may be disposed on the second insulating layer INS2 to cover the dummy electrode DME. The semiconductor layers S4, A4, and D4 of the fourth transistor T4 may be disposed on the third insulating layer INS3. The semiconductor layers S4, A4, and D4 may include an oxide semiconductor formed of a metal oxide. The oxide semiconductor may include a crystalline or amorphous oxide semiconductor.

The semiconductor layers S4, A4, and D4 may include a plurality of regions classified depending on whether the metal oxide is reduced. A region (hereinafter referred to as a "reduction region"), in which the metal oxide is reduced, may have conductivity higher than that of a region (hereinafter referred to as a "non-reduction region") in which the metal oxide is not reduced. The reduction region may serve as the source electrode or the drain electrode of the fourth transistor T4. The non-reduction region may substantially correspond to an active (or a channel) of the fourth transistor T4.

The fourth source region S4, the fourth channel region A4, and the fourth drain region D4 of the fourth transistor T4 may be formed from the semiconductor layers S4, A4, and D4. The fourth channel region A4 may be disposed between the fourth source region S4 and the fourth drain region D4.

A fourth insulating layer INS4 may be disposed on the third insulating layer INS3 to cover the semiconductor layers S4, A4, and D4. The fourth gate electrode G4 of the fourth transistor T4 may be disposed on the fourth insulating layer INS4. The fourth gate electrode G4 may be overlapping the fourth channel region A4, when viewed in a plan view.

A fifth insulating layer INS5 may be disposed on the fourth insulating layer INS4 to cover the fourth gate electrode G4. The structures of the source region, the channel region, the drain region, and the gate electrode of the third transistor T3 may be substantially the same as those of the fourth transistor T4.

The buffer layer BFL and the first to fifth insulating layers INS1 to INS5 may include inorganic layers. For example, the buffer layer BFL, the first insulating layer INS1, and the fourth insulating layer INS4 may include a silicon oxide layer, and the second insulating layer INS2 may include a silicon nitride layer.

The third and fifth insulating layers INS3 and INS5 may include a plurality of inorganic insulating layers that include different materials and are stacked on each other. For example, the third insulating layer INS3 may include a silicon nitride layer and a silicon oxide layer that are sequentially stacked, and the fifth insulating layer INS5 may include a silicon oxide layer and a silicon nitride layer that are sequentially stacked. A thickness of each of the third and fifth insulating layers INS3 and INS5 may be thicker than a thickness of each of the buffer layer BFL and the first insulating layer INS1, the second insulating layer INS2, and the fourth insulating layer INS4.

A connecting electrode CNE may be disposed between the sixth transistor T6 and the light emission element OLED. The connecting electrode CNE may electrically connect the sixth transistor T6 to the light emission element OLED. The connecting electrode CNE may include a first connecting electrode CNE1 and a second connecting electrode CNE2 disposed on the first connecting electrode CNE1.

The first connecting electrode CNE1 may be disposed on the fifth insulating layer INS5, and may be connected to the sixth drain region D6 through the first contact hole CH1 defined in the first to fifth insulating layers INS1 to INS5. A sixth insulating layer INS6 may be disposed on the fifth insulating layer INS5 to cover the first connecting electrode CNE1.

The second connecting electrode CNE2 may be disposed on the sixth insulating layer INS6. The second connecting electrode CNE2 may be connected to the first connecting electrode CNE1 through a second contact hole CH2 defined in the sixth insulating layer INS6.

A seventh insulating layer INS7 may be disposed on the sixth insulating layer INS6 to cover the second connecting electrode CNE2. The sixth insulating layer INS6 and the seventh insulating layer INS7 may include an inorganic layer or an organic layer.

The anode AE may be disposed on the seventh insulating layer INS7. The anode AE may be electrically connected to the second connecting electrode CNE2 through a third contact hole CH3 defined in the seventh insulating layer INS7.

A pixel defining layer PDL may be disposed on the anode AE and the seventh insulating layer INS7 to expose a given portion of the anode AE. The pixel defining layer PDL may include a light emission opening PX_OP to expose the given portion of the anode AE. In addition to the light emission opening PX_OP provided in the display region DA, additional openings may be provided in a portion, which is in the non-display region NDA (see FIG. 3), of the pixel defining layer PDL. The details thereof will be described below.

The hole control layer HCL may be disposed on the anode AE and the pixel defining layer PDL. The hole control layer HCL may be commonly disposed in the light emission region LEA and the non-light emission region NLEA. The hole control layer HCL may include a hole transport layer and a hole injection layer.

The light emission layer EML may be disposed on the hole control layer HCL. The light emission layer EML may be disposed in a region corresponding to the light emission opening PX_OP. The light emission layer EML may include an organic material or an inorganic material. The light emission layer EML may generate any one light of red light, green light, and blue light.

The electron control layer ECL may be disposed on the light emission layer EML and the hole control layer HCL. The electron control layer ECL may be commonly disposed in the light emission region LEA and the non-light emission region NLEA. The electron control layer ECL may include an electron transport layer and an electron injection layer.

The cathode CE may be disposed on the electron control layer ECL. The cathode CE may be commonly disposed in the pixels PX. In other words, the cathode CE may be commonly disposed on the light emission layers EML of the pixels PX.

The layers from the buffer layer BFL to the seventh insulating layer INS7 may be defined to be included in the circuit element layer DP-CL. The layer having the light emission element OLED may be defined as the display element layer DP-OLED.

The thin film encapsulating layer TFE may be disposed on the light emission element OLED. The thin film encapsulating layer TFE may include an inorganic layer, an organic layer, and an inorganic layer sequentially stacked. The inorganic layers may include an inorganic material to protect pixels PX from moisture/oxygen. The organic layer may include an organic material to protect the pixels PX from foreign substances such as dust particles.

The first driving voltage ELVDD may be applied to the anode AE, and the second driving voltage ELVSS may be applied to the cathode CE. Holes and electrons injected into the light emission layer EML are combined to form excitons, and the light emission element OLED may emit light as the excitons transition to the ground state. The light emission element OLED may emit light, and an image may be displayed.

FIG. 7 is a schematic plan view of a display panel according to an embodiment. FIG. 7 is a schematic plan view of the display panel illustrated in FIG. 4.

FIG. 4 is a view illustrating functional blocks of the display device DD, and FIG. 7 is a view illustrating a planar structure of the display panel DP.

Referring to FIG. 7, the display device DD may include the display panel DP, the scan driver SDV, a plurality of data drivers DDV, the light emission driver EDV, and a plurality of pads PD. The display panel DP may have the shape of a rectangle having a rounded corner, which corresponds to the shape of the display device DD.

The edges of the display panel DP may have longer sides extending in parallel in the first direction DR1 and shorter sides extending in parallel in the second direction DR2. The longer sides and the shorter sides of the display panel DP may correspond to rectangular sides. The edges of the display panel DP may include rounded corners connecting the longer sides and the shorter sides of the display panel DP. Each of the rounded corners may connect a longer side and a shorter side adjacent to each other.

The display panel DP may include the display region DA and the non-display region NDA which is disposed around the display region DA to surround or be adjacent to the display region DA. The display region DA may have the shape of a rectangle having a rounded corner, which corresponds to the shape of the display panel DP.

To have the shape of the rectangle having the rounded corner, the display region DA may include first to fourth sides SI1 to SI4 and first to third rounded corners CR1 to CR3. The first to fourth sides SI1 to SI4 may define four sides of the rectangle. The first to third rounded corners CR1 to CR3 may define four rounded corners of the rectangle.

The first side SI1 and the fourth side SI4 may extend in parallel in the first direction DR1 while facing each other in the second direction DR2. The second side SI2 and the third side SI3 may extend in parallel in the second direction DR2 while facing each other in the first direction DR1. The first side SI1 and the fourth side SI4 may extend longer than the second side SI2 and the third side SI3. The first side SI1 and the fourth side SI4 may be defined as the longer sides, and the second side SI2 and the third side SI3 may be defined as the shorter sides.

The second side SI2 and the third side SI3 may extend in the second direction DR2 while being adjacent to opposite ends of the first side SI1, respectively. The second side SI2 may be disposed adjacent to one end (or an end) of the first side SI1 while extending in the second direction DR2. The third side SI3 may be disposed adjacent to an opposite end of the first side SI1 while extending in the second direction DR2. One end of the second side SI2 may be adjacent to the one end of the first side SI1, and one end of the third side SI3 may be adjacent to the opposite end of the first side SI1.

The fourth side SI4 may extend in the first direction DR1 while being adjacent to an opposite end of the second side SI2 and an opposite end of the third side SI3. One end of the fourth side SI4 may be adjacent to the opposite end of the second side SI2, and an opposite end of the fourth side SI4 may be adjacent to the opposite end of the third side SI3.

The one end and the opposite end of the first side SI1 may be defined as opposite ends of the first side SI1, which are opposite to each other in the first direction DR1. The one end and the opposite end of the second side SI2 may be defined as opposite ends of the second side SI2, which are opposite to each other in the second direction DR2. The one end and the opposite end of the third side SI3 may be defined as opposite ends of the third side SI3, which are opposite to each other in the second direction DR2. The one end and the opposite end of the fourth side SI4 may be defined as opposite ends of the fourth side SI4, which are opposite to each other in the first direction DR1.

A distance in the first direction DR1 between the second side SI2 and the third side SI3 may be greater than a length of the first side SI1 and a length of the fourth side SI4. A distance in the second direction DR2 between the first side SI1 and the fourth side SI4 may be greater than a length of the second side SI2 and a length of the third side SI3.

When viewed in the second direction DR2, the first side SI1 and the fourth side SI4 may be disposed between the second side SI2 and the third side SI3. When viewed in the first direction DR1, the second side SI2 and the third side SI3 may be disposed between the first side SI1 and the fourth side SI4.

The first rounded corner CR1 may link the first side SI1 to the second side SI2. For example, the first rounded corner CR1 may link the one end of the first side SI1 and the one end of the second side SI2 which are adjacent to each other. The first rounded corner CR1 may have a curved shape which is convexly curved toward the non-display region NDA.

The second rounded corner CR2 may link the first side SI1 and the third side SI3. For example, the second rounded corner CR2 may link the opposite end of the first side SI1 and the one end of the third side SI3, which are adjacent to each other, to each other. The second rounded corner CR2 may have a curved shape which is convexly curved toward the non-display region NDA.

Two third rounded corners CR3 may link the opposite ends of the fourth side SI4 to the opposite end of the second side SI2 and the opposite end of the third side SI3, respectively. One third rounded corner CR3 may link the opposite end of the second side SI2 and the one end of the fourth side SI4, which are adjacent to each other, to each other. Another third rounded corner CR3 may link the opposite end of the third side SI3 and the opposite end of the fourth side SI4, which are adjacent to each other, to each other. The third rounded corners CR3 may have a curved shape convexly curved toward the non-display region NDA.

The first rounded corner CR1 and the second rounded corner CR2 may have shapes symmetrical to each other in the first direction DR1. The third rounded corners CR3 may have shapes symmetrical to each other in the first direction DR1. The first and second rounded corners CR1 and CR2 may have shapes symmetrical to each other about an axis extending in the second direction DR2, and the third rounded corners CR3 may have shapes symmetrical to each other about the axis extending in the second direction DR2.

The display panel DP may include the plurality of pixels PX, the plurality of scan lines SL1 to SLm, the plurality of data lines DL1 to DLn, and the plurality of light emission lines EL1 to ELm. The pixels PX may be disposed in the display region DA. The pixels PX may be connected to the scan lines SL1 to SLm, the data lines DL1 to DLn, and the light emission lines EL1 to ELm.

The scan lines SL1 to SLm may include the scan lines GIL1 to GILm, GCL1 to GCLm, GWL1 to GWLm, and GBL1 to GBLm illustrated in FIG. 4. For example, the i-th scan line among the scan lines SL1 to SLm may include the i-th write scan line GWLi, the i-th compensating scan line GCLi, the i-th initializing scan line GILi, and the i-th bias scan line GBLi. Accordingly, the above-described scan signals may be applied to the pixels PX through the scan lines SL1 to SLm.

The data lines DL1 to DLn and the light emission lines EL1 to ELm may be the same as the data lines DL1 to DLn and the light emission lines EL1 to ELm illustrated in FIG. 4.

The scan driver SDV and the light emission driver EDV may be disposed in the non-display region NDA to be adjacent to the sides of the display panel DP opposite to each other in the first direction DR1. The scan driver SDV may be adjacent to the second side SI2, the first rounded corner CR1, and the third rounded corner CR3 connected to the second side SI2. The light emission driver EDV may be adjacent to the third side SI3, the second rounded corner CR2, and the third rounded corner CR3 connected to the third side SI3. In the specification, the scan driver SDV or the light emission driver EDV may be described as a "driver".

A portion of the scan driver SDV, which is adjacent to the first rounded corner CR1, and a portion of the scan driver SDV, which is adjacent to the third rounded corner CR3 connected to the second side SI2, may have a curved shape. A portion of the light emission driver EDV, which is adjacent to the second rounded corner CR2 and a portion of the light emission driver EDV, which is adjacent to the third rounded corner CR3 connected to the third side SI3, may have a curved shape.

As illustrated in FIG. 7, the data driver DDV illustrated in FIG. 4 may be provided substantially in the form of the plurality of data drivers DDV in the display panel DP. The data driver DDV may be disposed in a portion, which is adjacent to one of the opposite sides of the display panel DP opposite to each other in the second direction DR2, of the non-display region NDA. When viewed in a plan view, the data drivers DDV may be adjacent to a lower end of the display panel DP. For example, the data drivers DDV may be adjacent to the first side SI1.

The scan lines SL1 to SLm may extend in the first direction DR1 and may be connected to the pixels PX and the scan driver SDV. The data lines DL1 to DLn may extend in the second direction DR2 and may be connected to the pixels PX and the data drivers DDV. The light emission lines EL1 to ELm may extend in the first direction DR1 and may be connected to the pixels PX and the light emission driver EDV.

The data drivers DDV may be spaced apart from each other in the first direction DR1. A given number of data lines may be connected to each of the data drivers DDV. For example, although two data drivers DDV are illustrated, the number of data drivers DDV is not limited thereto. For example, the number of data drivers DDV may also increase, as the areas of left and right portions of the display panel DP increase.

The pads PD may be disposed in a portion, which is adjacent to the lower end of the display panel DP, of the non-display region NDA and may be closer to the lower end of the display panel DP, than the data driver DDV. The data drivers DDV may be connected to the pads PD. The data lines DL1 to DLn may be connected to the data drivers DDV, and the data drivers DDV may be connected to the pads PD corresponding to the data lines DL1 to DLn.

The timing controller T-C and the voltage generator VG illustrated in FIG. 4 may be mounted on a printed circuit board and connected to the pads PD through the printed circuit board.

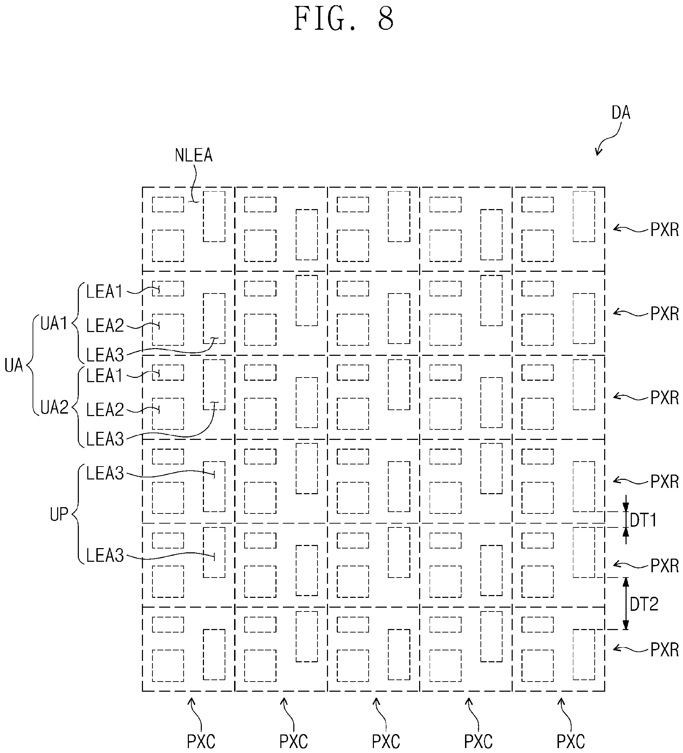

FIG. 8 is an enlarged schematic plan view of a display region according to an embodiment.

Referring to FIG. 8, the display region DA may include a plurality of light emission regions LEA1, LEA2, and LEA3, and may include a non-light emission region NLEA adjacent to the plurality of light emission regions LEA1, LEA2, and LEA3. The non-light emission region NLEA forms boundaries among the plurality of light emission regions LEA1, LEA2, and LEA3.

The plurality of light emission regions LEA1, LEA2, and LEA3 may be disposed to correspond to the pixels PX of FIG. 7, respectively. Each of the pixels PX may include a light emission element, and the plurality of light emission regions LEA1, LEA2, and LEA3 may be regions for emitting light generated from the light emission element.

The plurality of light emission regions LEA1, LEA2, and LEA3 may include the first light emission region LEA1 for forming first color light, the second light emission region LEA2 for forming second color light, and the third light emission region LEA3 for forming third color light. According to an embodiment, the first color light may be red light, the second color light may be green light, and the third color light may be blue light. The light emission element OLED described in FIG. 6 may be disposed in each of the plurality of light emission regions LEA1, LEA2, and LEA3. The light emission layer EML may be at least disposed in each of the plurality of light emission regions LEA1, LEA2, and LEA3. Light emission layers EML including different materials may be disposed in the plurality of light emission regions LEA1, LEA2, and LEA3. In other words, the light emission elements OLED corresponding to the first light emission region LEA1, the second light emission region LEA2, and the third light emission region LEA3, respectively, may include the light emission layers EML including different materials.

The areas of the first light emission region LEA1, the second light emission region LEA2, and the third light emission region LEA3 may be different from each other, but the disclosure is not necessarily limited thereto. According to an embodiment, the first light emission region LEA1 may have the smallest area and the third light emission region LEA3 may be the largest area.

The first light emission region LEA1, the second light emission region LEA2, and the third light emission region LEA3 may define one unit light emission region UA. The unit light emission region UA is a repetitive arrangement unit of the light emission regions disposed in the display region DA. According to an embodiment, the unit light emission region UA may include a first unit light emission region UA1 and a second unit light emission region UA2.

Referring to the first unit light emission region UA1 and the second unit light emission region UA2, the first light emission region LEA1 and the second light emission region LEA2 may be disposed at one side (a left side of FIG. 8) of the third light emission region LEA3 in the first direction DR1. The second light emission region LEA2 of each of the first unit light emission region UA1 and the second unit light emission region UA2 may be disposed at one side (a lower side of FIG. 8) of the first light emission region LEA1 in the second direction DR2.

In the second direction DR2, the position of the third light emission region LEA3 in relation to the first light emission region LEA1 and the second light emission region LEA2 may be varied. In the first unit light emission region UA1, the position of the third light emission region LEA3 in relation to the first light emission region LEA1 and the second light emission region LEA2 may be a lower position, in the second direction DR2. In the second unit light emission region UA2, the position of the third light emission region LEA3 in relation to the first light emission region LEA1 and the second light emission region LEA2 may be a higher position, in the second direction DR2. The shifting degrees of the position of the third light emission region LEA3 in relation to the first light emission region LEA1 and the second light emission region LEA2 may be different from each other in the first unit light emission region UA1 and the second unit light emission region UA2, when viewed in the second direction DR2. According to an embodiment, the third light emission region LEA3 in the second unit light emission region UA2 may be shifted more, as compared to the third light emission region LEA3 in the first unit light emission region UA1. However, the disclosure is not limited thereto. For example, the shifting degrees of the position of the third light emission region LEA3 in relation to the first light emission region LEA1 and the second light emission region LEA2 may be equal to each other in the first unit light emission region UA1 and the second unit light emission region UA2, when viewed in the second direction DR2.

The first unit light emission region UA1 and the second unit light emission region UA2 may be alternately disposed in the first direction DR1, in a pixel row PXR. The first unit light emission region UA1 and the second unit light emission region UA2 may be alternately disposed in the second direction DR2 in a pixel column PXC. The third light emission region LEA3 in the first unit light emission region UA1 and the third light emission region LEA3 in the second unit light emission region UA2 may be arranged in a given rule through such an arrangement of the first unit light emission region UA1 and the second unit light emission region UA2. The third light emission region LEA3 in the first unit light emission region UA1 and the third light emission region LEA3 in the second unit light emission region UA2, which are adjacent to each other in the second direction DR2, are spaced apart from each other by a first distance DT1 to be closer to each other. The third light emission region LEA3 in the first unit light emission region UA1 and the third light emission region LEA3 in the second unit light emission region UA2, which are spaced apart from each other by the first distance DT1, may define a light emission region pair UP. Light emission region pairs UP are spaced apart from each other by a second distance DT2 in each pixel column PXC. The second distance DT2 may be greater than the first distance DT1.

FIG. 9 is an enlarged schematic plan view of a portion of a display panel according to an embodiment. FIG. 9 illustrates an enlarged schematic plan view of a portion, which is adjacent to the first rounded corner CR1, of the display panel DP according to an embodiment illustrated in FIG. 7.

Referring to FIG. 9, the display region DA of the display panel according to an embodiment may include the plurality of unit light emission regions UA, and each of the plurality of unit light emission regions UA may include the first light emission region LEA1, the second light emission region LEA2, and the third light emission region LEA3. The plurality of unit light emission regions UA may be repeatedly arranged in each of the first and second directions DR1 and DR2.

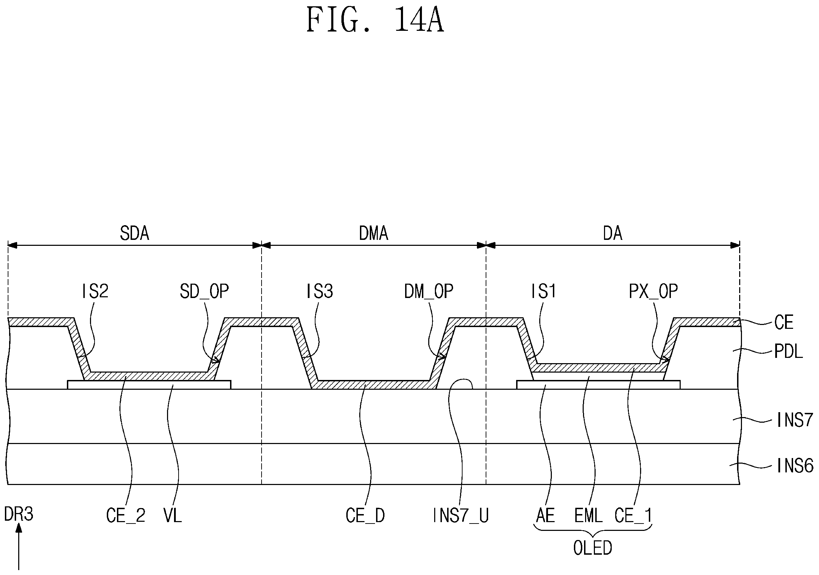

The scan driver SDV may be disposed in the non-display region NDA and may be disposed adjacent to the second side SI2 and the first rounded corner CR1. A portion, which is adjacent to the first rounded corner CR1, of the scan driver SDV may have a curved shape following the first rounded corner CR1. According to an embodiment, the region for the scan driver SDV may be described as a "driving region SDA". Although the region for the scan driver SDV is illustrated as the driving region SDA in FIG. 9, the region for the light emission driver EDV described with reference to FIG. 7 may also be described as the driving area. Each of the scan driver SDV and the light emission driver EDV may include a plurality of transistors, and a voltage line VL (see FIG. 14A) to be described later may be disposed in the driving region SDA for the scan driver SDV and the light emission driver EDV.

The non-display region NDA may include the dummy region DMA provided between the driving region SDA and the display region DA. The dummy region DMA may be a region in which the scan driver SDV is not disposed. The dummy region DMA may be a region between the region for the scan driver SDV and the region for the pixel PX (see FIG. 7).

The non-display region NDA may further include the bezel region BZA. The bezel region BZA may be a region overlapping the light blocking patterns WBM (see FIG. 2) described above. The driving region SDA and the dummy region DMA may be provided to be closer to the display region DA, rather than the bezel region BZA.

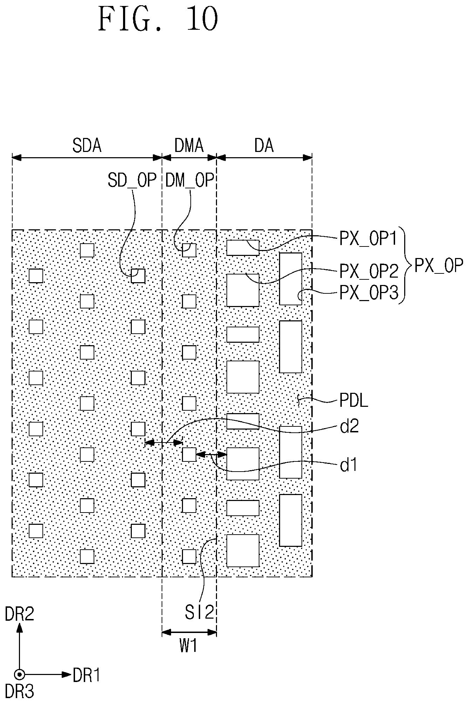

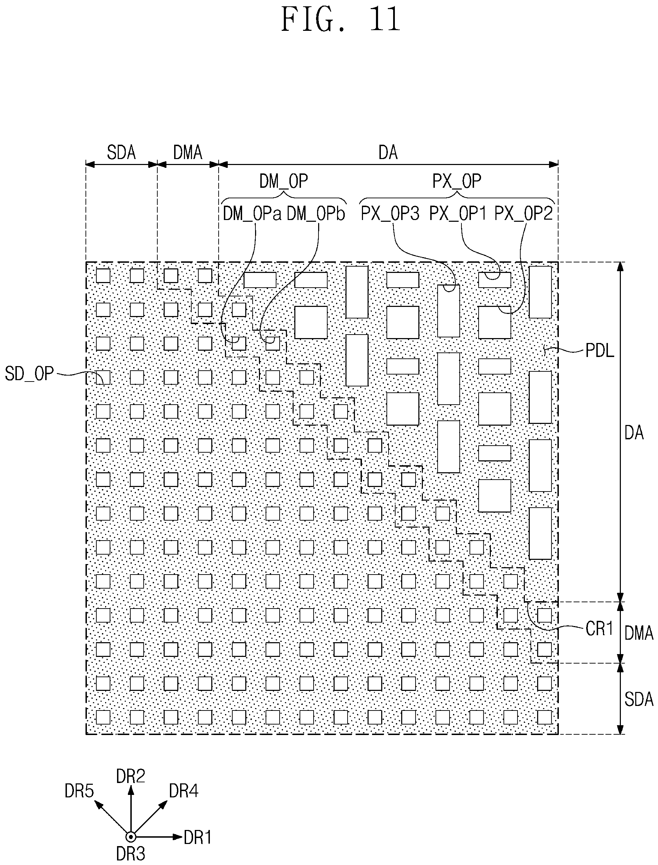

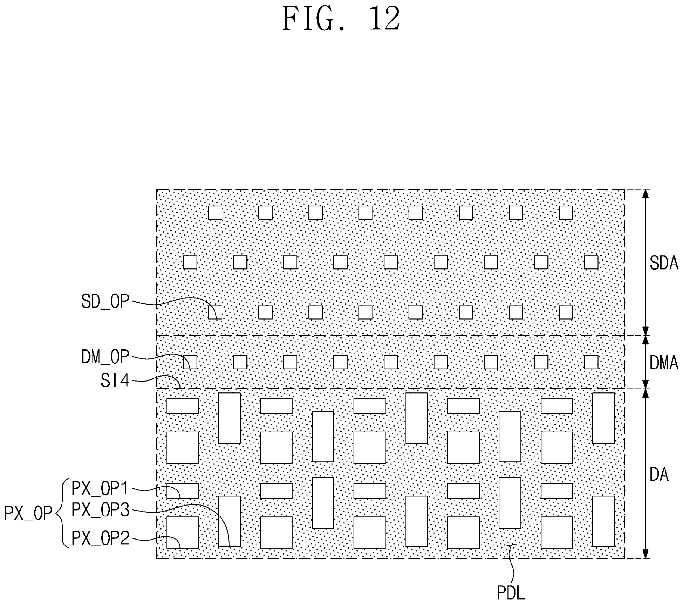

FIGS. 10 to 12 are enlarged schematic plan views of various components of a display panel according to an embodiment. FIGS. 10 to 12 illustrate a planar shape of the plurality of openings provided in the pixel defining layer PDL included in the display panel according to an embodiment. FIG. 10 illustrates planar shapes of openings in the pixel defining layer PDL provided in the display region DA, the driving region SDA, and the dummy region DMA, in a portion, which is adjacent to the second side SI2, of the display region DA illustrated in FIG. 7. FIG. 11 illustrates planar shapes of openings in the pixel defining layer PDL provided in the display region DA, the driving region SDA, and the dummy region DMA, in a portion, which is adjacent to the first rounded corner CR1, of the display region DA illustrated in FIG. 7. FIG. 12 illustrates planar shapes of openings in the pixel defining layer PDL provided in the display region DA, the driving region SDA, and the dummy region DMA, in a portion, which is adjacent to the fourth side SI4, of the display region DA illustrated in FIG. 7.

Referring to FIGS. 7, 9, and 10 together, the pixel defining layer PDL according to an embodiment may include the plurality of light emission openings PX_OP provided in the display region DA. The pixel defining layer PDL according to an embodiment further may include a plurality of driving openings SD_OP provided in the driving region SDA and a plurality of dummy openings DM_OP provided in the dummy region DMA.

The plurality of light emission openings PX_OP may be provided to correspond to the plurality of emission regions LEA1, LEA2, and LEA3 described above. The plurality of light emission openings PX_OP may have the shape corresponding to the shape of the plurality of emission regions LEA1, LEA2, and LEA3. The plurality of light emission openings PX_OP may include a first light emission opening PX_OP1 corresponding to the first light emission region LEA1, a second light emission opening PX_OP2 corresponding to the second light emission region LEA2, and a third light emission opening PX_OP3 corresponding to the third light emission region LEA3. The first light emission opening PX_OP1, the second light emission opening PX_OP2, and the third light emission opening PX_OP3 may have different planar areas. According to an embodiment, the first light emission opening PX_OP1 may have the smallest area and the third light emission opening PX_OP3 may be the largest area.

Each of the first light emission opening PX_OP1 and the second light emission openings PX_OP2 may be provided in plural. The first light emission opening PX_OP1 and the second light emission opening PX_OP2 may be alternately arranged in the second direction DR2. The third light emission opening PX_OP3 may be provided to be spaced apart from each of the first light emission opening PX_OP1 and the second light emission opening PX_OP2 in the first direction DR1. The third light emission opening PX_OP3 may be provided in the form of a plurality of third light emission openings PX_OP3 which are arranged along in second direction DR2.

At least a portion of the light emission element OLED described with reference to FIG. 6 may be disposed in each of the plurality of light emission openings PX_OP. At least the light emission layer EML among components, which are included in the light emission element OLED, may be disposed in each of the plurality of light emission openings PX_OP.

The plurality of driving openings SD_OP may be provided in the driving region SDA of the non-display region NDA. At least a portion of the plurality of driving openings SD_OP is overlapping the scan driver SDV described above, when viewed in a plan view. The plurality of driving openings SD_OP may be provided in the driving region SDA, and are spaced apart from the plurality of light emission openings PX_OP provided in the display region DA in one direction. In a portion, which is adjacent to the second side SI2, of the display region DA, the plurality of driving openings SD_OP may be spaced apart from the plurality of light emission openings PX_OP in the first direction DR1.

The plurality of driving openings SD_OP may have the shape different from the shape of each of the plurality of light emission openings PX_OP, when viewed in a plan view. According to an embodiment, a planar area of each of the plurality of driving openings SD_OP may be smaller than a planar area of each of the plurality of light emission openings PX_OP. The plurality of driving openings SD_OP may have the shape of a rectangle, when viewed in a plan view. However, the disclosure is not limited thereto, and the plurality of driving openings SD_OP may have various shapes when viewed in a plan view. For example, the plurality of driving openings SD_OP may have the shape of a circle, the shape of an oval, the shape of a rectangle, or the shape of a rectangle having a rounded corner.

The plurality of dummy openings DM_OP may be provided in the dummy region DMA of the non-display region NDA. The dummy region DMA may be defined as a region for the plurality of dummy openings DM_OP. The plurality of dummy openings DM_OP is in a non-overlap state with the scan driver SDV described above, when viewed in a plan view. The plurality of dummy openings DM_OP may be provided in the dummy region DMA, and disposed between the plurality of light emission openings PX_OP provided in the display region in DA and the plurality of driving openings SD_OP provided in the driving region SDA. In the portion, which is adjacent to the second side SI2, of the display region DA, the plurality of dummy openings DM_OP may be disposed between the plurality of light emission openings PX_OP and the plurality of driving openings SD_OP, in the first direction DR1.

The plurality of dummy openings DM_OP may have the shape substantially the same as the shape of the plurality of light emission openings PX_OP or the plurality of driving openings SD_OP, when viewed in a plan view. For example, as illustrated in FIG. 10, the plurality of dummy openings DM_OP may have substantially the same as the shape of the plurality of driving openings SD_OP, when viewed in a plan view. The plurality of dummy openings DM_OP may have the shape of a circle, the shape of an oval, the shape of a rectangle, or the shape of a rectangle having a rounded corner, when viewed in a plan view. In the specification, the wording "substantially the same as" includes the meaning that shapes are the same as each other physically, and the meaning that the shapes may have the difference by an error caused in the fabricating process, even in the same design. The plurality of dummy openings DM_OP may be formed in a process the same as that of the plurality of light emission openings PX_OP or the plurality of driving openings SD_OP to have a shape substantially the same as that of the plurality of light emission openings PX_OP or the plurality of driving openings SD_OP, when viewed in a plan view.

When viewed in a direction in which the light emission opening PX_OP and the driving opening SD_OP are spaced apart from each other, the minimum distance between any one of the plurality of dummy openings DM_OP and the light emission opening PX_OP closest to the any one dummy opening may be smaller than or equal to the minimum distance between any one of the plurality of dummy openings DM_OP and the driving opening SD_OP closest to the any one dummy opening. According to an embodiment, in a portion, which is adjacent to the second side SI2, of the display region DA, the direction in which the light emission opening PX_OP and the driving opening SD_OP are spaced apart from each other, may be the first direction DR1. In this case, when viewed in the first direction DR1, the minimum distance between any one of the plurality of dummy openings DM_OP and the light emission opening PX_OP closest to the any one dummy opening may be a first gap 'd1'. When viewed in the first direction DR1, the minimum distance between any one of the plurality of dummy openings DM_OP and the driving opening SD_OP closest to the any one dummy opening may be a second gap 'd2'. In this case, the first gap 'd1' may be smaller than or equal to the second gap 'd2'. The first gap 'd1' may be in the range from about 50% to about 100% of the second gap 'd2'.

The plurality of dummy openings DM_OP may be arranged in a direction intersecting the direction in which the light emission opening PX_OP and the driving opening SD_OP are spaced apart from each other. The dummy region DMA in which the plurality of dummy openings DM_OP are arranged may extend in a direction intersecting the direction in which the light emission opening PX_OP and the driving opening SD_OP are spaced apart from each other. In the portion, which is adjacent to the second side SI2, of the display region DA, the plurality of dummy openings DM_OP may be arranged in the second direction DR2, and the dummy region DMA may extend in the second direction DR2.

The dummy region DMA may extend in the second direction DR2 and may have a first width 'W1' in the first direction DR1. The first width 'W1' of the dummy region DMA may be in the range of about 40 µm to about 80 µm.

The dummy region DMA may be provided adjacent to at least a portion of the first to fourth sides SI1 to SI4 and the first to third rounded corners CR1 to CR3 of the display region DA. As illustrated in FIG. 10, the dummy region DMA may be provided adjacent to the second side SI2. By way of example, as illustrated in FIG. 11, the dummy region DMA may be provided adjacent to the first rounded corner CR1, or may be provided adjacent to the fourth side SI4 as illustrated in FIG. 12. The dummy region DMA may be provided adjacent to the third side SI3, the second rounded corner CR2, and the third rounded corner CR3.

Referring to FIGS. 7 and 9 to 11 together, the pixel defining layer PDL according to an embodiment may include the plurality of light emission openings PX_OP provided in the display region DA. The pixel defining layer PDL according to an embodiment may further include the plurality of driving openings SD_OP provided in the driving region SDA and the plurality of dummy openings DM_OP provided in the dummy region DMA.

The plurality of driving openings SD_OP may be provided in the driving region SDA, and are spaced apart from the plurality of light emission openings PX_OP, which are provided in the display region DA, in one direction. In the portion, which is adjacent to the first rounded corner CR1, of the display region DA, the plurality of driving openings SD_OP may be spaced apart from the plurality of light emission openings PX_OP in a fourth direction DR4, which is a direction between the first and second directions DR1 and DR2.

The plurality of dummy openings DM_OP may be provided in the dummy region DMA, and are disposed between the plurality of light emission openings PX_OP provided in the display region DA and the plurality of driving openings SD_OP provided in the driving region SDA. In the portion, which is adjacent to the first rounded corner CR1, of the display region DA, the plurality of dummy openings DM_OP may be disposed between the plurality of light emission openings PX_OP and the plurality of driving openings SD_OP in the fourth direction DR4.

The plurality of dummy openings DM_OP may be arranged in the direction intersecting the direction in which the light emission opening PX_OP and the driving opening SD_OP are spaced apart from each other. The dummy region DMA in which the plurality of dummy openings DM_OP are arranged may extend in the direction intersecting the direction in which the light emission opening PX_OP and the driving opening SD_OP are spaced apart from each other. In the portion, which is adjacent to the first rounded corner CR1, of the display region DA, the plurality of dummy openings DM_OP may be arranged in a fifth direction DR5 intersecting the fourth direction DR4, and the dummy region DMA may extend in the fifth direction DR5.

The plurality of dummy openings DM_OP may be provided in a plurality of columns in the direction intersecting the direction in which the light emission opening PX_OP and the driving opening SD_OP are spaced apart from each other. The plurality of dummy openings DM_OP may include a first dummy opening DM_OPa and a second dummy opening DM_OPb. The first dummy opening DM_OPa may be disposed to be relatively adjacent to the driving opening SD_OP. The second dummy opening DM_OPb may be disposed to be relatively adjacent the light emission opening PX_OP. The second dummy opening DM_OPb may be disposed between the first dummy opening DM_OPa and the light emission opening PX_OP. The first dummy opening DM_OPa and the second dummy opening DM_OPb may be provided in a plural form, and may be arranged in the direction intersecting the spacing direction. In the portion, which is adjacent to the first rounded corner CR1, of the display region DA, the plurality of first dummy openings DM_OPa and the plurality of second dummy openings DM_OPb may be arranged in the fifth direction DR5.

Referring to FIGS. 7 and 9 to 11 together, the pixel defining layer PDL according to an embodiment may include the plurality of light emission openings PX_OP provided in the display region DA. The pixel defining layer PDL according to an embodiment further may include the plurality of driving openings SD_OP provided in the driving region SDA and the plurality of dummy openings DM_OP provided in the dummy region DMA.

The plurality of driving openings SD_OP may be provided in the driving region SDA, and are spaced apart from the plurality of light emission openings PX_OP provided in the display region DA in one direction. In the portion, which is adjacent to the first rounded corner CR1 of the display region DA, the plurality of driving openings SD_OP may be spaced apart from the plurality of light emission openings PX_OP in the fourth direction DR4, which is the direction between the first and second directions DR1 and DR2.

The plurality of dummy openings DM_OP may be provided in the dummy region DMA, and are disposed between the plurality of light emission openings PX_OP provided in the display region DA and the plurality of driving openings SD_OP provided in the driving region SDA. In the portion, which is adjacent to the first rounded corner CR1, of the display region DA, the plurality of dummy openings DM_OP may be disposed between the plurality of light emission openings PX_OP and the plurality of driving openings SD_OP in the fourth direction DR4.

The plurality of dummy openings DM_OP may be arranged in the direction intersecting the direction in which the light emission opening PX_OP is spaced apart from the driving opening SD_OP. The dummy region DMA in which the plurality of dummy openings DM_OP are arranged may extend in the direction intersecting the direction intersecting the direction in which the light emission opening PX_OP and the driving opening SD_OP are spaced apart from each other. In the portion, which is adjacent to the first rounded corner CR1, of the display region DA, the plurality of dummy openings DM_OP may be arranged in a fifth direction DR5 intersecting the fourth direction DR4, and the dummy region DMA may extend in the fifth direction DR5.

The plurality of dummy openings DM_OP may be provided in a plurality of columns in the direction intersecting the direction in which the light emission opening PX_OP and the driving opening SD_OP are spaced apart from each other. The plurality of dummy openings DM_OP may include the first dummy opening DM_OPa and the second dummy opening DM_OPb. The first dummy opening DM_OPa may be disposed to be relatively adjacent to the driving opening SD_OP. The second dummy opening DM_OPb may be disposed to be relatively adjacent to the light emission opening PX_OP. The second dummy opening DM_OPb may be provided between the first dummy opening DM_OPa and the light emission opening PX_OP. The first dummy opening DM_OPa and the second dummy opening DM_OPb may be provided in a plural form, and may be arranged in the direction intersecting the direction in which the plurality of light emission openings PX_OP are spaced apart from the plurality of driving openings SD_OP. In the portion, which is adjacent to the first rounded corner CR1, of the display region DA, the plurality of first dummy openings DM_OPa and the plurality of second dummy openings DM_OPb may be arranged in the fifth direction DR5.

Referring to FIGS. 7, 9, 10 and 12, the pixel defining layer PDL according to an embodiment may include the plurality of light emission openings PX_OP provided in the display region DA. The pixel defining layer PDL according to an embodiment further may include the plurality of driving openings SD_OP provided in the driving region SDA and the plurality of dummy openings DM_OP provided in the dummy region DMA.

The plurality of driving openings SD_OP may be provided in the driving region SDA, and are spaced apart from the plurality of light emission openings PX_OP provided in the display region DA in one direction. In the portion, which is adjacent to the fourth side SI4, of the display region DA, the plurality of driving openings SD_OP may be spaced apart from the plurality of light emission openings PX_OP in the second direction DR2. Although a separate driver is not disposed in the driving region SDA, the voltage line VL (see FIG. 14A) to be described later may be disposed, in the portion which is adjacent to the fourth side SI4,

The plurality of dummy openings DM_OP may be provided in the dummy region DMA, and are disposed between the plurality of light emission openings PX_OP provided in the display region DA and the plurality of driving openings SD_OP provided in the driving region SDA. In the portion, which is adjacent to the fourth side SI4, of the display region DA, the plurality of dummy openings DM_OP may be disposed between the plurality of light emission openings PX_OP and the plurality of driving openings SD_OP, the second direction DR2.

The plurality of dummy openings DM_OP may be arranged in the direction intersecting the direction in which the light emission opening PX_OP and the driving opening SD_OP are spaced apart from each other. The dummy region DMA in which the plurality of dummy openings DM_OP are arranged may extend in the direction intersecting the direction in which the light emission opening PX_OP and the driving opening SD_OP are spaced apart from each other. In the portion, which is adjacent to the fourth side SI4, of the display region DA, the plurality of dummy openings DM_OP may be arranged in the first direction DR1, and the dummy region DMA may extend in the first direction DR1.

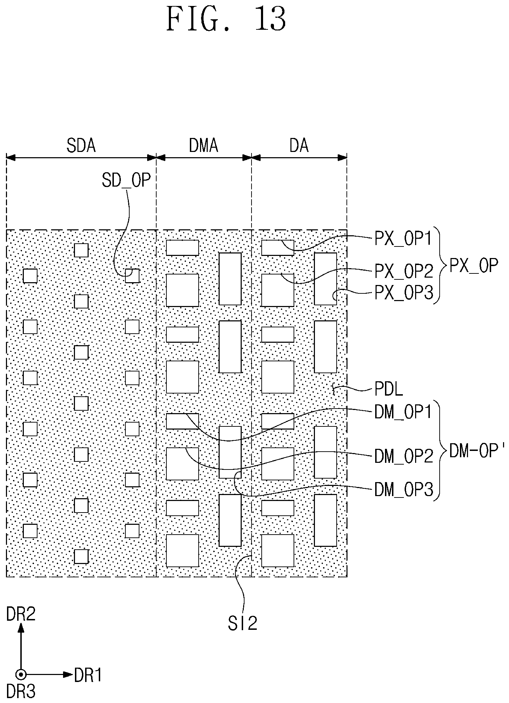

FIG. 13 is an enlarged schematic plan view of various components of a display panel according to an embodiment. FIG. 13 illustrates a planar shape of a plurality of openings provided in the pixel defining layer PDL included in the display panel according to an embodiment, and FIG. 13 illustrates a planar shape of openings in the pixel defining layer PDL provided in the display region DA, the driving region SDA, and the dummy region DMA, in the portion, which is adjacent to the second side SI2, of the display region DA illustrated in FIG. 7. FIG. 13 illustrates a partial plane of a display panel including the plurality of dummy openings DM_OP of the dummy region DMA according to an embodiment that may be different from an embodiment illustrated in FIG. 10.

Referring to FIG. 13, unlike an embodiment illustrated in FIG. 10, a plurality of dummy openings DM-OP' may have substantially the same shape as at least some of a plurality of light emission openings PX_OP when viewed in a plan view. The plurality of dummy openings DM-OP' may have substantially the same shape as at least one of a first light emission opening PX_OP1, a second light emission opening PX_OP2, and a third light emission opening PX_OP3 included in the plurality of light emission openings PX_OP. For example, the plurality of dummy openings DM-OP' may include a first sub-dummy opening DM_OP1 having the same shape as the first light emission opening PX_OP1, a second sub-dummy opening DM_OP2 having the same shape as the second light emission opening PX_OP2, and a third sub-dummy opening DM_OP3 having the same shape as the third light emission opening PX_OP3. Unlike FIG. 13, the plurality of dummy openings DM-OP' may include openings having the same shape as some of the first light emission opening PX_OP1, the second light emission opening PX_OP2, and the third light emission opening PX_OP3 and may not include openings corresponding to remaining openings of the first light emission opening PX_OP1, the second light emission opening PX_OP2, and the third light emission opening PX_OP3. For example, the plurality of dummy openings DM-OP' may include only the third sub-dummy opening DM_OP3 having the same shape as the third light emission opening PX_OP3. By way of example, the plurality of dummy openings DM-OP' may include the first sub-dummy opening DM_OP1 having the same shape as the first light emission opening PX_OP1, and the second sub-dummy opening DM_OP2 having the same shape as the second light emission opening PX_OP2.

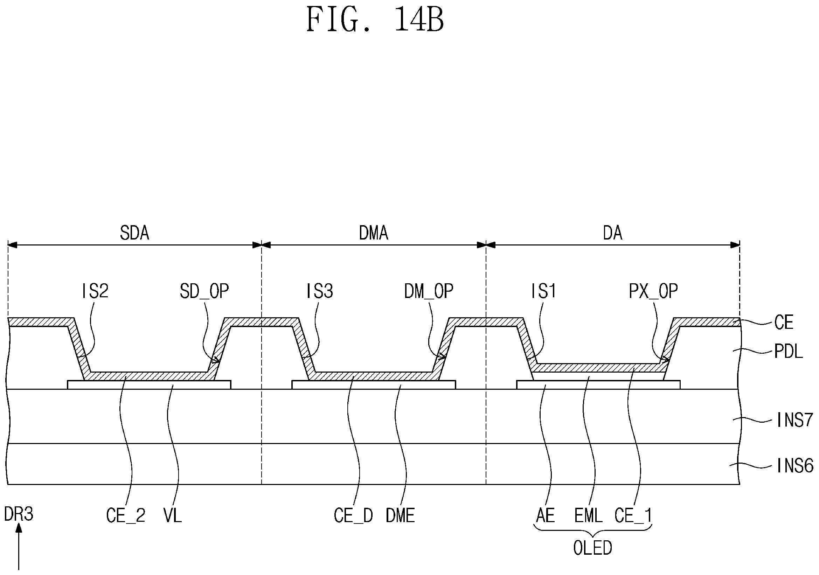

FIGS. 14A and 14B are schematic cross-sectional views of various components of a display panel according to an embodiment. FIGS. 14A and 14B illustrate schematic cross-sectional views of the arrangement shape of openings, which are provided in each the display region DA, the dummy region DMA, and the driving region SDA sequentially arranged in one direction or in a direction, of the pixel defining layer PDL, and the cathode CE disposed to correspond to the openings.

Referring to FIGS. 9, 10, and 14A together, the pixel defining layer PDL according to an embodiment may include the light emission opening PX_OP provided in the display region DA, the driving opening SD_OP provided in the driving region SDA, and the dummy openings DM_OP provided in the dummy region DMA. Each of the light emission opening PX_OP, the driving opening SD_OP, and the dummy openings DM_OP may be formed by removing at least a portion of the pixel defining layer PDL such that a component disposed under or below the pixel defining layer PDL is exposed.

The light emission opening PX_OP may be provided in the display region DA to expose a portion of the anode AE. The light emission layer EML of the light emission element OLED may be disposed in the light emission opening PX_OP. The cathode CE may be provided as a common layer in the display region DA, the driving region SDA, and the dummy region DMA, and may include a light emission part CE_1 disposed in the light emission opening PX_OP. The light emission layer EML may be disposed between the anode AE and the light emission part CE_1 of the light emission element OLED.

The driving opening SD_OP may be provided in the driving region SDA, and a portion of a voltage line VL may be exposed through the driving opening SD_OP. The voltage line VL may be disposed in the driving region SDA, and may be disposed on the same layer as the anode AE of the light emission element OLED. The voltage line VL may be disposed on, for example, the seventh insulating layer INS7.

The cathode CE may include a driving part CE_2 provided to be overlapping the driving region SDA and disposed in the driving opening SD_OP. The driving part CE_2 may be disposed in the driving opening SD_OP and may make contact with a top surface of the voltage line VL which is exposed. The driving part CE_2 may be electrically connected to the voltage line VL and receive a data voltage from the voltage line VL.

The dummy opening DM_OP is provided in the dummy region DMA, and a component disposed under or below the pixel defining layer PDL may be exposed through the dummy opening DM_OP. For example, a top surface of the uppermost layer of a plurality of insulating layers included in the circuit element layer DP-CL (see FIG. 6) may be exposed through the dummy opening DM_OP. As illustrated in FIG. 14A, a top surface INS7_U of the seventh insulating layer INS7, which is the uppermost layer of the plurality of insulating layers, may be exposed through the dummy opening DM_OP. The cathode CE may include a dummy part CE_D provided to be overlapping the dummy region DMA and disposed in the dummy opening DM_OP. The dummy part CE_D may be disposed in the dummy opening DM_OP to make contact with the exposed top surface INS7_U of the seventh insulating layer INS7.

Each of the light emission opening PX_OP, the driving opening SD_OP, and the dummy opening DM_OP may include tilting surfaces IS1, IS2, and IS3 having a given taper angle. The tilting surfaces IS1, IS2, and IS3 of each of the light emission opening PX_OP, the driving opening SD_OP, and the dummy opening DM_OP may have an acute angle with respect to the top surface INS7_U of the seventh insulating layer INS7. The light emission opening PX_OP may include the first tilting surface IS1, the driving opening SD_OP may include the second tilting surface IS2, and the dummy opening DM_OP may include the third tilting surface IS3.

The slope of the third tilting surface IS3 may be substantially equal to any one of the slopes of the first tilting surface IS1 and the slope of the second tilting surface IS2. For example, as illustrated in FIG. 14A, the first tilting surface IS1, the second tilting surface IS2, and the third tilting surface IS3 may have an equal slope. By way of example, the slope of the third tilting surface IS3 may be substantially equal to the slope of the second tilting surface IS2, and may be equal to the slope of the first tilting surface IS1.

A portion of the cathode CE disposed inside each of the light emission opening PX_OP, the driving opening SD_OP, and the dummy opening DM_OP is disposed on each of the tilting surfaces IS1, IS2, and IS3. The cathode CE is disposed at an upper portion of each of the first tilting surface IS1, the second tilting surface IS2, and the third tilting surface IS3, and may make contact with each of the first tilting surface IS1, the second tilting surface IS2, and the third tilting surface IS3. The light emission part CE_1 of the cathode CE may be directly disposed on the first tilting surface IS1. The driving part CE_2 of the cathode CE may be directly disposed on the second tilting surface IS2. The dummy part CE_D of the cathode CE may be directly disposed on the third tilting surface IS3.

In the display device according to an embodiment, the plurality of dummy openings DM_OP may be provided in the dummy region DMA disposed between the display region DA and the driving region SDA when viewed in a plan view, thereby preventing the display defect in which a portion of the non-display region NDA adjacent to the display region DA is viewed as a dark color.

Unlike an embodiment, in the case that the additional dummy opening DM_OP is not provided in the dummy region DMA, a difference in reflection characteristic may be made among the dummy region DMA, the display region DA adjacent to the dummy region DMA, and the driving region SDA. The light emission opening PX_OP and the driving opening SD_OP may be provided in the display region DA and the driving region SDA, respectively, for the electrical connection between the anode AE and a voltage line VL. The portion of the cathode CE may be disposed along each of the tilting surfaces IS1 and IS2 of the light emission opening PX_OP and the driving opening SD_OP, and the cathode CE including metal may be disposed along the tilting surfaces IS1 and IS2. In the case that an additional dummy opening DM_OP is not provided, a tilting surface is not provided at a portion corresponding to the dummy region DMA. Accordingly, the difference in reflectance may be made among the display region DA, and the driving region SDA, and the dummy region DMA. Accordingly, when viewed from the outside, the difference in visibility may be made among the display region DA, the driving region SDA, and the dummy region DMA.

In the display device according to an embodiment, the plurality of dummy openings DM_OP may be provided in the dummy region DMA disposed between the display region DA and the driving region SDA, and the cathode CE is also disposed on the third tilting surface IS3 of the dummy opening DM_OP, such that the reflectance of the dummy region DMA may be adjusted to be similar to the reflectance of the display region DA and the driving region SDA. Accordingly, defects in which the dummy region DMA is viewed as being in a dark color from the outside are prevented. Accordingly, the display quality of the display device may be improved.

Referring to FIG. 14B, unlike an embodiment illustrated in FIG. 14A, the display device according to an embodiment may further include a dummy electrode DME disposed in the dummy region DMA. The dummy electrode DME may be disposed in the dummy region DMA, and may be disposed in a layer the same as the layers of the anode AE and the voltage line VL of the light emission element OLED. The dummy electrode DME may be disposed on, for example, the seventh insulating layer INS7.

The dummy electrode DME may be provided in a floating state in which an additional voltage is not applied. Accordingly, even if a portion of the cathode CE makes contact with the dummy electrode DME, an additional signal may not be provided to the portion of the cathode CE which makes contact with the dummy electrode DME.

The dummy opening DM_OP may be provided in the dummy region DMA, and the component disposed under or below the pixel defining layer PDL may be exposed through the dummy opening DM_OP. For example, as illustrated in FIG. 14B, a portion of the top surface of the dummy electrode DME may be exposed through the dummy opening DM_OP. The cathode CE may include the dummy part CE_D provided to be overlapping the dummy region DMA and disposed in the dummy opening DM_OP. The dummy part CE_D may be disposed in the dummy opening DM_OP to make contact with the exposed top surface of the dummy electrode DME.

The display device according to the embodiment can be applied to various electronic devices. The electronic device according to one embodiment includes the display device described above, and may further include modules or devices having additional functions in addition to the display device.

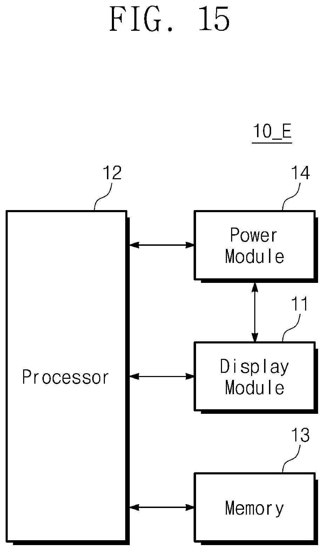

FIG. 15 is a block diagram of an electronic device according to one embodiment. Referring to FIG. 15, the electronic device 10_E according to one embodiment may include a display module 11, a processor 12, a memory 13, and a power module 14. The display module 11 may include the display panel DP as described in FIGS. 3 to 14B.

The processor 12 may include at least one of a central processing unit (CPU), an application processor (AP), a graphic processing unit (GPU), a communication processor (CP), an image signal processor (ISP), and a controller.

The memory 13 may store data information necessary for the operation of the processor 12 or the display module 11. When the processor 12 executes an application stored in the memory 13, an image data signal and/or an input control signal is transmitted to the display module 11, and the display module 11 can process the received signal and output image information through a display screen.

The power module 14 may include a power supply module such as a power adapter or a battery device, and a power conversion module that converts the power supplied by the power supply module to generate power necessary for the operation of the electronic device 10_E.

At least one of the components of the electronic device 10_E described above may be included in the display device according to the embodiments described above. In addition, some of the individual modules functionally included in one module may be included in the display device, and other parts may be provided separately from the display device. For example, the display device may include the display module 11, and the processor 12, the memory 13, and the power module 14 may be provided in the form of other devices within the electronic device 11 other than the display device.

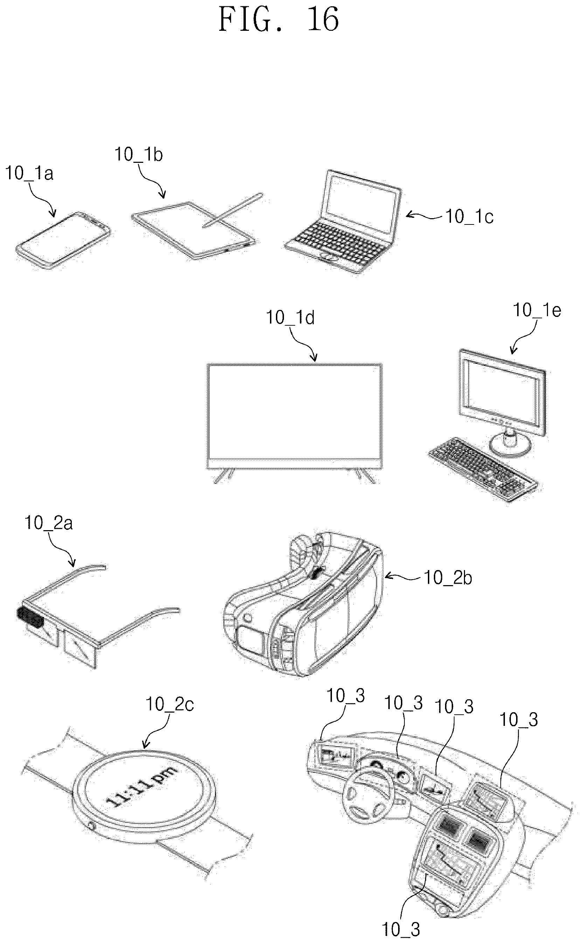

FIG. 16 is a schematic diagram of an electronic device according to various embodiments. Referring to FIG. 16, various electronic devices to which display devices according to embodiments are applied may include not only image display electronic devices such as a smart phone 10_1a, a tablet PC 10_1b, a laptop 10_1c, a TV 10_1d, and a desk monitor 10_1e, but also wearable electronic devices including display modules such as smart glasses 10_2a, a head mounted display 10_2b, and a smart watch 10_2c, and vehicle electronic devices 10_3 including display modules such as a CID (Center Information Display) and a room mirror display arranged on a dashboard, center fascia, and dashboard of an automobile.

As described above, according to an embodiment, as the dummy openings may be provided to be overlapping a portion, which is adjacent to the display region, of the non-display region, the portion of the non-display region show the reflective characteristic similar to that of the display region and the region having openings to receive the data voltage. Accordingly, the display device improved in display quality by preventing the display defect in which the portion of the non-display region adjacent to the display region is viewed differently from another portion.

Although an embodiment has been described for illustrative purposes, those skilled in the art will appreciate that various modifications, and substitutions are possible, without departing from the scope of the disclosure as disclosed in the accompanying claims. The scope of protection of the disclosure should also be construed by the attached claims, and all equivalents thereof should be construed as being included within the scope of the disclosure.

While the disclosure has been described with reference to embodiments thereof, it will be apparent to those of ordinary skill in the art that various changes and modifications may be made thereto without departing from the scope of the disclosure and as set forth in the following claims.

## Claims

1. A display device comprising:
a base layer divided into a display region and a non-display region surrounding at least a portion of the display region;
a circuit element layer including a driver disposed on the base layer and overlapping the non-display region; and
a display element layer disposed on the circuit element layer,
wherein the display element layer includes:
a pixel defining layer disposed on the circuit element layer; and
a light emission element overlapping the display region and including a light emission layer, wherein
the pixel defining layer includes:
a light emission opening overlapping the display region and at least having the light emission layer disposed in the light emission opening;
a driving opening overlapping the non-display region, and overlapping the driver; and
a dummy opening overlapping the non-display region and disposed between the light emission opening and the driving opening, and
the dummy opening has a substantially planar shape substantially the same as a planar shape of the light emission opening or the driving opening.

2. The display device of claim 1, wherein each of the light emission opening, the driving opening, and the dummy opening includes a tilting surface having a substantially acute angle with respect to an upper surface of the circuit element layer.

3. The display device of claim 2, wherein
the light emission element further includes:
an anode disposed on the circuit element layer; and
a cathode facing the anode, and
the light emission layer is disposed between the anode and the cathode.

4. The display device of claim 3, wherein the cathode is disposed on the tilting surface.

5. The display device of claim 3 or claim 4, wherein
the circuit element layer further includes a plurality of insulating layers disposed on the base layer, and
the anode is directly disposed on an uppermost layer among the plurality of insulating layers.

6. The display device of claim 5, wherein:
(i) the cathode includes a dummy part disposed in the dummy opening, and
the dummy part is directly disposed on the uppermost layer among the plurality of insulating layers; or
(ii) the display element layer further includes a dummy electrode disposed on the circuit element layer,
the cathode includes a dummy part disposed in the dummy opening, and
the dummy part contacts the dummy electrode.

7. The display device of any one of claims 3 to 6, wherein
the cathode includes a driving part disposed in the driving opening,
the display element layer further includes a voltage line disposed on the circuit element layer, and
the driving part contacts the voltage line.

8. The display device of any one of claims 1 to 7, wherein:
(i) each of the driving opening and the dummy opening has a shape substantially of a circle, a shape substantially of an oval, a shape substantially of a rectangle, or a shape of a rectangle having a substantially rounded corner, when viewed in a plan view; and/or
(ii) a minimum distance between the dummy opening and the light emission opening is about less than or about equal to a minimum distance between the driving opening and the dummy opening.

9. The display device of any one of claims 1 to 8, wherein the light emission opening includes:
a first light emission opening;
a second light emission opening spaced apart from the first light emission opening; and
a third light emission opening spaced apart from each of the first light emission opening and the second light emission opening, and
the dummy opening has a substantially planar shape substantially the same as a planar shape of at least one of the first light emission opening, the second light emission opening, and the third light emission opening, when viewed in a plan view.

10. The display device of any one of claims 1 to 9, wherein:
(i) the display region includes:
a first side extending in a first direction,
a second side extending in a second direction intersecting the first direction adjacent to an end of the first side, and
a first substantially rounded corner connecting the end of the first side to an end, adjacent to the end of the first side, of the second side, and
wherein the dummy opening is adjacent to at least one of the first side, the second side, and the first substantially rounded corner; and/or
(ii) the display device further comprises:
a window disposed on the display element layer,
wherein the window includes:
a base member; and
a light blocking pattern disposed below the base member and overlapping the non-display region, and
each of the driving opening and the dummy opening is closer to the display region than to the light blocking pattern, when viewed in a plan view.

11. The display device of any one of claims 1 to 10, wherein:
(i) a dummy region including the dummy opening extends in a direction intersecting a direction in which the light emission opening and the driving opening are spaced apart from each other; and/or
(ii) a dummy region including the dummy opening has a width in a range of about 40 µm to about 80 µm.

12. The display device of any one of claims 1 to 11, wherein:
(i) the dummy opening includes:
a first dummy opening adjacent to the driving opening; and
a second dummy opening disposed between the first dummy opening and the light emission opening when viewed in a plan view; and/or
(ii) the circuit element layer further includes:
at least one transistor electrically connected to the light emission element.

13. A display device comprising:
a base layer divided into a display region and a non-display region surrounding at least a portion of the display region;
a circuit element layer including a driver disposed on the base layer and overlapping the non-display region; and
a display element layer disposed on the circuit element layer, wherein
the display element layer includes:
a pixel defining layer disposed on the circuit element layer; and
a light emission element overlapping the display region,
the pixel defining layer includes:
a light emission opening overlapping the display region;
a driving opening overlapping the non-display region and overlapping the driver; and
a dummy opening overlapping the non-display region and disposed between the light emission opening and the driving opening, and
each of the light emission opening, the driving opening, and the dummy opening includes a tilting surface having a substantially acute angle with respect to an upper surface of the circuit element layer.

14. The display device of claim 13, wherein
the light emission element includes:
an anode disposed on the circuit element layer;
a cathode facing the anode; and
a light emission layer disposed between the anode and the cathode, and
the cathode is disposed on the tilting surface.

15. An electronic device comprising:
a display module including a display panel; and
a processor including at least one of a central processing unit, an application processor, a graphic processing unit, a communication processor, an image signal processor, and a controller, wherein
the display panel includes:
a base layer divided into a display region and a non-display region surrounding at least a portion of the display region;
a circuit element layer including a driver disposed on the base layer and overlapping the non-display region; and
a display element layer disposed on the circuit element layer,
wherein the display element layer includes:
a pixel defining layer disposed on the circuit element layer; and
a light emission element overlapping the display region and including a light emission layer, wherein
the pixel defining layer includes:
a light emission opening overlapping the display region and at least having the light emission layer disposed in the light emission opening;
a driving opening overlapping the non-display region, and overlapping the driver; and
a dummy opening overlapping the non-display region and disposed between the light emission opening and the driving opening, and
the dummy opening has a substantially planar shape substantially the same as a planar shape of the light emission opening or the driving opening.
